(19) Europäisches Patentamt
European Patent Office
Office européen des brevets

(11) **EP 3 940 900 B1**

(12) **EUROPEAN PATENT SPECIFICATION**

(45) Date of publication and mention
of the grant of the patent:
**14.02.2024 Bulletin 2024/07**

(21) Application number: **20305815.1**

(22) Date of filing: **15.07.2020**

(51) International Patent Classification (IPC):
***H01S 5/06*** *(2006.01)*

(52) Cooperative Patent Classification (CPC):
**H01S 5/06**

(54) **TUNABLE LASER STABILIZATION**

ABSTIMMBARE LASERSTABILISIERUNG

STABILISATION DE LASERS ACCORDABLES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.01.2022 Bulletin 2022/03**

(73) Proprietor: **Nokia Solutions and Networks Oy 02610 Espoo (FI)**

(72) Inventors:
• **Bitauld, David**
**91300 Massy (FR)**

• **Stern, Brian**
**New Jersey, 07733 (US)**

(74) Representative: **Novagraaf Technologies Bâtiment O2 2, rue Sarah Bernhardt CS90017 92665 Asnières-sur-Seine Cedex (FR)**

(56) References cited:
**EP-A1- 1 291 988        WO-A1-99/04467**
**DE-T2- 69 432 438**

**Description**

TECHNICAL FIELD

Various example embodiments relate generally to lasers and, more particularly but not exclusively, to supporting stabilization of tunable lasers.

BACKGROUND

Lasers may be used in many contexts for many purposes. For example, in various types of communication networks lasers may be used to support optical communications via optical fibers, via free-space optical communications, and so forth. Some lasers are tunable, enabling output characteristics of the laser, such as the wavelength of the laser, to be reconfigured in a controlled manner.

EP 1 291 988 A1 relates to a multi-section laser diode that can be switched between different wavelengths, more especially to a laser system comprising a control circuit that enables a multi-section laser diode to be switched rapidly between different wavelengths.

SUMMARY

The invention is defined by the appended claims.

In at least some example embodiments, an apparatus is provided. The apparatus may include a tunable laser, a wavemeter, and a set of analog functions. The tunable laser may be configured to produce a laser output. The tunable laser may include a set of tunable elements configured to be tuned based on a set of laser tuning signals. The set of tunable elements may include at least two tunable elements and the set of laser tuning signals may include at least two laser tuning signals. The wavemeter may be configured to generate a set of electrical signals based on the laser output and to provide the set of electrical signals to the set of analog functions. The set of analog functions may be configured to control the set of laser tuning signals based on the set of electrical signals. In at least some example embodiments, the set of analog functions may be configured to receive a set of laser drive signals, a set of gain coefficients, and a set of expected wavemeter electrical signals. In at least some example embodiments, the set of laser tuning signals may be generated based on modulation of the set of laser drive signals based on the set of gain coefficients and the set of expected wavemeter electrical signals. In at least some example embodiments, the set of analog functions may be configured to receive a set of laser drive signals, a set of gain factor signals, and a phase set point signal. In at least some example embodiments, the set of laser tuning signals may be generated based on modulation of the set of laser drive signals based on the set of gain factor signals and the phase set point signal. In at least some example embodiments, the set of analog functions may be configured to receive a set of laser drive signals, a set of gain factor signals, and a set of target phase signals. In at least some example embodiments, the set of laser tuning signals may be generated based on modulation of the set of laser drive signals based on the set of gain factor signals and the set of target phase signals. In at least some example embodiments, the set of analog functions has a set of tunable parameters associated therewith, wherein the set of tunable parameters may be controlled based on a set of signals received from a controller. In at least some example embodiments, the set of signals received from the controller is based on the set of electrical signals. In at least some example embodiments, the apparatus may further include a controller configured to receive the set of electrical signals from the wavemeter and to control the set of laser tuning signals based on the set of electrical signals. In at least some example embodiments, the controller may be configured to provide a set of control signals to the set of analog functions based on the set of electrical signals, and the set of analog functions may be configured to control the set of laser tuning signals based on the set of control signals. In at least some example embodiments, the set of control signals may include at least one of a set of expected wavemeter electrical signals, a set of gain coefficients, a set of gain factor signals, a phase set point signal, or a set of target phase signals. In at least some example embodiments, the controller may be configured to provide a set of laser drive signals to the set of analog functions, and the set of analog functions may be configured to modulate the set of laser drive signals based on the set of electrical signals. In at least some example embodiments, the controller may be configured to provide a set of control signals to the set of analog functions based on the set of electrical signals, and the set of analog functions may be configured to modulate the set of laser drive signals based on the set of control signals.

In at least some example embodiments, a method is provided. The method may include producing, by a tunable laser including a set of tunable elements configured to be tuned based on a set of laser tuning signals, a laser output. The set of tunable elements may include at least two tunable elements. The set of laser tuning signals may include at least two laser tuning signals. The method may include generating, by a wavemeter based on the laser output, a set of electrical signals. The method may include controlling, by a set of analog functions based on the set of electrical signals, the set of laser tuning signals. In at least some example embodiments, the method may include receiving, by the set of analog functions, a set of laser drive signals, a set of gain coefficients, and a set of expected wavemeter electrical signals. In at least some example embodiments, the method may include generating, based on modulation of the set of laser drive signals based on the set of gain coefficients and the set of expected wavemeter electrical signals, the set of laser tuning signals. In at least some example embodiments, the method may include receiving, by he set of analog functions a set of laser drive signals, a set of gain factor signals, and a phase set point signal. In at least some example embodiments, the method may include generating, based on modulation of the set of laser drive signals based on the set of gain factor signals and the phase set point signal, the set of laser tuning signals. In at least some example embodiments, the method may include receiving, by the set of analog functions, a set of laser drive signals, a set of gain factor signals, and a set of target phase signals. In at least some example embodiments, the method may include generating, based on modulation of the set of laser drive signals based on the set of gain factor signals and the set of target phase signals, the set of laser tuning signals. In at least some example embodiments, the set of analog functions has a set of tunable parameters associated therewith, and the method may include controlling the set of tunable parameters based on a set of signals received from a controller. In at least some example embodiments, the set of signals received from the controller is based on the set of electrical signals. In at least some example embodiments, the method may further include receiving, by a controller from the wavemeter, the set of electrical signals and controlling the set of laser tuning signals based on the set of electrical signals. In at least some example embodiments, the method may include providing, by the controller to the set of analog functions based on the set of electrical signals, a set of control signals and controlling, by the set of analog functions based on the set of control signals, the set of laser tuning signals. In at least some example embodiments, the set of control signals may include at least one of a set of expected wavemeter electrical signals, a set of gain coefficients, a set of gain factor signals, a phase set point signal, or a set of target phase signals. In at least some example embodiments, the method may include providing, by the controller to the set of analog functions, a set of laser drive signals and modulating, by the set of analog functions based on the set of electrical signals, the set of laser drive signals. In at least some example embodiments, the method may include providing, by the controller to the set of analog functions based on the set of electrical signals, a set of control signals and modulating, by the set of analog functions based on the set of control signals, the set of laser drive signals.

In at least some example embodiments, an apparatus is provided. The apparatus may include means for producing a laser output, means for analyzing the laser output, and means for performing analog operations. The means for producing the laser output may be configured to tune the means for producing the laser output based on a set of laser tuning signals. The means for producing the laser output may include at least two tunable elements. The set of laser tuning signals may include at least two laser tuning signals. The means for analyzing the laser output may be configured to generate a set of electrical signals based on the laser output and to provide the set of electrical signals to the set of analog functions. The means for performing analog operations may be configured to control the set of laser tuning signals based on the set of electrical signals. In at least some example embodiments, the means for performing analog operations may be configured to receive a set of laser drive signals, a set of gain coefficients, and a set of expected wavemeter electrical signals. In at least some example embodiments, the set of laser tuning signals may be generated based on modulation of the set of laser drive signals based on the set of gain coefficients and the set of expected wavemeter electrical signals. In at least some example embodiments, the means for performing analog operations may be configured to receive a set of laser drive signals, a set of gain factor signals, and a phase set point signal. In at least some example embodiments, the set of laser tuning signals may be generated based on modulation of the set of laser drive signals based on the set of gain factor signals and the phase set point signal. In at least some example embodiments, the means for performing analog operations may be configured to receive a set of laser drive signals, a set of gain factor signals, and a set of target phase signals. In at least some example embodiments, the set of laser tuning signals may be generated based on modulation of the set of laser drive signals based on the set of gain factor signals and the set of target phase signals. In at least some example embodiments, the means for performing the analog operations has a set of tunable parameters associated therewith, and the set of tunable parameters may be controlled based on a set of signals received from a controller. In at least some example embodiments, the set of signals received from the controller is based on the set of electrical signals. In at least some example embodiments, the apparatus may further include means for controlling the set of laser tuning signals. The means for controlling the set of laser tuning signals may be configured to receive the set of electrical signals from the means for analyzing the laser output and to control the set of laser tuning signals based on the set of electrical signals. In at least some example embodiments, the means for controlling the set of laser tuning signals may be configured to provide a set of control signals to the means for performing analog operations based on the set of electrical signals, and the means for performing analog operations may be configured to control the set of laser tuning signals based on the set of control signals. In at least some example embodiments, the set of control signals may include at least one of a set of expected wavemeter electrical signals, a set of gain coefficients, a set of gain factor signals, a phase set point signal, or a set of target phase signals. In at least some example embodiments, the means for controlling the set of laser tuning signals may be configured to provide a set of laser drive signals to the means for performing analog operations, and the means for performing analog operations may be configured to modulate the set of laser drive signals based on the set of electrical signals. In at least some example embodiments, the means for controlling the set of laser tuning signals may be configured to provide a set of control signals to the means for performing analog operations based on the set of electrical signals, and the means for performing analog operations may be configured to modulate the set of laser drive signals based on the set of control signals.

BRIEF DESCRIPTION OF THE DRAWINGS

The teachings herein can be readily understood by considering the following detailed description in conjunction with the accompanying drawings, in which:

FIG. 1 depicts an example embodiment of a system configured to support stabilization of a tunable laser;
FIG. 2 depicts an example embodiment of a system configured to support stabilization of a tunable laser;
FIG. 3 depicts an example embodiment of a system configured to support stabilization of a tunable laser;
FIG. 4 depicts an example embodiment of a system configured to support stabilization of a tunable laser;
FIG. 5 depicts an example embodiment of a gain element configured for use in a system configured to support stabilization of a tunable laser;
FIG. 6 depicts an example embodiment of a method configured to support stabilization of a tunable laser; and
FIG. 7 depicts an example embodiment of a computer suitable for use in performing various functions presented herein.

To facilitate understanding, identical reference numerals have been used herein, wherever possible, in order to designate identical elements that are common among the various figures.

DETAILED DESCRIPTION

Various example embodiments for supporting tuning of a tunable laser are presented. Various example embodiments for supporting tuning of a tunable laser may be configured to support tuning of a tunable laser based on a wavemeter. Various example embodiments for supporting tuning of a tunable laser based on a wavemeter may be configured to support tuning of the tunable laser based on a fast feedback loop from the wavemeter to the tunable laser and a slow feedback loop from the wavemeter to the tunable laser that is controlled by a controller. It will be appreciated that these and various other example embodiments and advantages or potential advantages of supporting tuning of a tunable laser may be further understood by way of reference to the various figures, which are discussed further below.

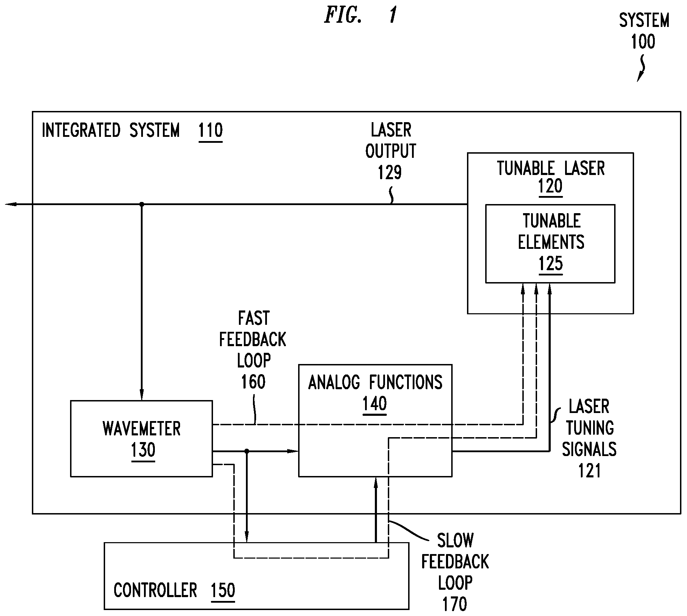

FIG. 1 depicts an example embodiment of a system configured to support stabilization of a tunable laser.

The system 100 includes a tunable laser and, thus, may be employed within various contexts and environments in which tunable lasers may be used. For example, the system 100 may be employed for communications (e.g., fiber-based optical communication networks, free-space optical communication networks, and the like), spectroscopy, photochemistry, or the like. It is noted that various example embodiments presented herein may be employed for supporting tuning of tunable lasers within various other contexts and environments in which tunable lasers may be employed.

The system 100 is configured to support calibration and stabilization of a tunable laser, as the ability to tune a tunable laser may be useful for various reasons. For example, drifting of the wavelength of a laser, whether caused by environmental changes such as temperature or other types of perturbations, may be detrimental to system performance. Alternatively, for example, reconfiguration of the wavelength of a laser may be necessary or desirable for enabling certain functionality. It is noted that calibration or stabilization of a tunable laser may necessary or desirable for various other reasons.

The system 100 includes an integrated system 110 and a controller 150. The integrated system 110 includes a tunable laser 120, a wavemeter 130, and a set of analog functions 140. The controller 150 is configured to provide various control functions for the integrated system 110. The integrated system 110 operates in the analog domain and the controller 150 operates in the digital domain and, thus, it will be appreciated that, although omitted for purposes of clarity, a set of conversion elements may be used to support exchange of information between the integrated system 110 and the controller 150 (e.g., analog-to-digital converters (ADCs) may be used for sending information from the integrated system 110 to the controller 150 and digital-to-analog converters (DACs) may be used for sending information from the controller 150 to the integrated system 110). The system further includes a fast feedback loop 160 and a slow feedback loop 170, each of which is configured to support tuning of the tunable laser 120.

The integrated system 110, an indicated above, includes the tunable laser 120, the wavemeter 130, and the set of analog functions 140. It will be appreciated that here, the term "integrated" may refer to a number of different arrangements of the tunable laser 120, the wavemeter 130, and the set of analog functions 140. For example, in at least some example embodiments, the term "integrated" may refer to an arrangement in which the tunable laser 120, the wavemeter 130, and the set of analog functions 140 are on the same chip. For example, in at least some example embodiments, the term "integrated" may refer to an arrangement in which the tunable laser 120, the wavemeter 130, and the set of analog functions 140 are packaged together in some form (e.g., in a system, an apparatus, a device, or the like) even though certain elements may not be on the same chip (e.g., the tunable laser 120 and the wavemeter 130 may be on separate chips integrated in such a way that they are packaged together, the elements may be implemented such that analog circuitry and digital circuitry are separated, or the like). It will be appreciated that other arrangements of the tunable laser 120, the wavemeter 130, and the set of analog functions 140, which may or may not be considered to be integrated, may be supported. It will be appreciated that references herein to integrated system also may be read more generally as being references to a system (e.g., a system at least including the tunable laser 120, the wavemeter 130, and the set of analog functions 140).

The tunable laser 120 is a laser configured to produce a laser output 129 having an output wavelength. The tunable laser 120 may support various output wavelengths and may be configured based on various materials and/or designs which may be dependent on the various output wavelengths supported. For example, integrated tunable lasers with output wavelengths near 1.3 um or 1.5 um are often based on III-V materials, sometimes in combination with an extended laser cavity in silicon waveguides. The III-V semiconductor waveguide provides optical gain based on an injected electrical current. The wavelength may be tuned using other elements inside the laser cavity, such as tunable filters. In the case of a hybrid III-V/silicon tunable laser, the silicon photonic circuit may have filters which, as an example, may be implemented as micro-ring resonator bandpass filters where the refractive index of the rings may be changed using some tuning mechanism, such as thermal heating, to change the resonance position of the ring and, thus, the output wavelength of the laser output. It will be appreciated that the tunable laser 120 may be based on these materials and/or designs as well as various other materials and/or designs. It is noted that references herein to the tunable laser 120 or other related tunable lasers may be read more generally as being references to means for providing a laser output, such that the means for providing a laser output as discussed herein may be the tunable laser 120 (or other similar tunable lasers presented herein) and/or other suitable means and associated equivalents for providing a laser output in accordance with various example embodiments presented herein.

The tunable laser 120 is tunable such that the output wavelength of the laser output 129 may be controlled. The tunable laser 120 may be configured to tune the output wavelength of the laser output 129 by sweeping the output wavelength across a range of the spectrum, by switching between wavelengths or sets of wavelengths, or the like. The tunable laser 120 may be tuned based on a set of tunable elements 125 of the tunable laser 120. The tunable laser 120 may be tuned based on various laser tuning signals 121 which may be used to control tuning of the set of tunable elements 125 of the tunable laser 120. The tunable laser 120 may be considered to have laser tuning parameters associated therewith where the laser tuning parameters may have values that may be set by the laser tuning signals 121 to tune the tunable laser 120 to produce a desired output wavelength of the laser output 129 (e.g., each of the tunable elements 125 may be considered to have a laser tuning parameter associated therewith where setting of the values of the laser tuning parameters that are associated with the tunable elements 125 may tune the tunable elements 125 such that the tunable laser 120 produces a desired output wavelength of the laser output 129). The laser tuning signals 121 may be controlled based on the fast feedback loop 160 within the analog domain of the integrated system 110 and based on the slow feedback loop 170 that includes interaction between the analog domain of the integrated system 110 and the digital domain of the controller 150. The fast feedback loop 160 may be controlled based on the slow feedback loop 170.

As used herein, the terms "fast feedback loop" and "slow feedback loop" are to be understood comparatively with regard to differences in their respective response times. Such response times may vary depending on the specific design of the tunable laser, while the differences exist. As non-limiting examples, in some embodiments the order of magnitude for the fast feedback loop may be nanoseconds and the order of the slow feedback loop may be microseconds or milliseconds, while in other embodiments the order of magnitude for the fast feedback loop may be microseconds and the order of magnitude for the slow feedback loop may be milliseconds. The fast feedback loop 160 and the slow feedback loop 170 in FIG. 1, may thus have different feedback response times which may vary depending on the tunable laser 120.

The tunable laser 120 is tuned based on the laser tuning signals 121 and, thus, based on control of the laser tuning signals 121. The laser tuning signals 121 may be drive signals which may be used to drive the tunable laser 120, including driving and, thus, controlling, the set of tunable elements 125 of the tunable laser 120. The laser tuning signals 121 may be generated based on drive signals which may be provided by the controller 150 and which may be modulated by the set of analog functions 140. The drive signals provided by the controller 150 may be modulated by the set of analog functions 140 to provide the laser tuning signals 121 (e.g., based on the fast feedback loop 160 within the analog domain of the integrated system 110 for tuning the tunable laser 120 based on faster fluctuations of wavelength and based on the slow feedback loop 170 that includes interaction between the analog domain of the integrated system 110 and the digital domain of the controller 150 for tuning the tunable laser 120 based on slower fluctuations of wavelength). The laser tuning signals 121 used to tune the tunable elements 125 of the tunable laser 120 may be generated in various ways (e.g., based on use of code points for the drive signals from the controller 150 such that the code points may be modified by the set of analog functions 140 based on feedback from the wavemeter 130 and the controller 150, based on generation of the values of the drive signals without use of code points, or the like, as well as various combinations thereof).

The tunable laser 120 is tuned based on the laser tuning signals 121, which may vary depending on the set of tunable elements 125 of the tunable laser 120. The tunable elements 125 of the tunable laser 120 may vary for different lasers and the laser tuning signals 121 may vary depending on the set of tunable elements 125 of the tunable laser 120 since different types of tunable elements 125 of the tunable laser 120 may be controlled using different types of laser tuning signals 121. For example, the set of tunable elements 125 of the tunable laser 120 may include a phase shifter, in which case the laser tuning signals 121 may include an electrical signal (e.g., a voltage, a current, or the like) for the phase to tune the optical length of the cavity of the tunable laser 120. For example, the set of tunable elements 125 of the tunable laser 120 may include a phase shifter and a Vernier effect filter including a pair of Verner rings, in which case the laser tuning signals 121 may include an electrical signal (e.g., a voltage, a current, or the like) for the phase to tune the optical length of the cavity of the tunable laser 120 and a pair of electrical signals (e.g., voltages, currents, or the like) to tune the pair of Vernier rings of the Vernier effect filter. For example, other tunable elements 125 may include filters (e.g., rings or other types of filters), tunable distributed Bragg reflector (DBR) gratings, or the like, as well as various combinations thereof. For example, the laser tuning signals 121 may include voltages, currents, values, or the like, as well as various combinations thereof. It will be appreciated that the tunable laser 120 may include various other tunable elements 125 and that the tunable elements 125 may be tuned based on various other laser tuning signals 121.

The wavemeter 130 is configured to support tuning of the wavelength of the laser output 129 of the tunable laser 120. The wavemeter 130 is configured to support tuning of the wavelength of the laser output 129 of the tunable laser 120 by using a response of the wavemeter 130 to the laser output 129 of the tunable laser 120 as a feedback to control the wavelength of the laser output 129 of the tunable laser 120. The wavemeter 130 is configured to measure the wavelength of the laser output 129 of the tunable laser 120 and to support tuning of the wavelength of the laser output 129 of the tunable laser 120 based on the measured wavelength of the laser output 129 of the tunable laser 120. The wavemeter 130 is configured to support tuning of the wavelength of the laser output 129 of the tunable laser 120 by providing feedback to the tunable elements 125 of the tunable laser 120 based on the measured wavelength of the laser output 129 of the tunable laser 120. The wavemeter 130 may support tuning of the wavelength of the laser output 129 of the tunable laser 120 by generating a set of electrical signals based on the measured wavelength of the laser output 129 of the tunable laser 120 and providing the set of electrical signals to the set of analog functions 140 for use by the analog functions 140 to provide fast path tuning of the wavelength of the laser output 129 of the tunable laser 120 and providing the set of electrical signals to the controller 150 for use by the controller 150 to provide slow path tuning of the wavelength of the laser output 129 of the tunable laser 120. The wavemeter 130 includes one or more interferometers providing one or more sets of I/Q outputs, respectively, where such sets of I/Q outputs may be provided to the set of analog functions 140 for use by the analog functions 140 to provide fast path tuning of the wavelength of the laser output 129 of the tunable laser 120 and to the controller 150 for use by the controller 150 to provide slow path tuning of the wavelength of the laser output 129 of the tunable laser 120. It is noted that references herein to the wavemeter 130 or other related wavemeters may be read more generally as being references to means for analyzing a laser output, such that the means for analyzing a laser output as discussed herein may be the wavemeter 130 (or other similar wavemeters presented herein) and/or other suitable means and associated equivalents for analyzing a laser output in accordance with various example embodiments presented herein.

The set of analog functions 140 is configured to support tuning of the wavelength of the laser output 129 of the tunable laser 120. The set of analog functions 140 is configured to support fast path tuning of the wavelength of the laser output 129 of the tunable laser 120. The set of analog functions 140 may support tuning of the wavelength of the laser output 129 of the tunable laser 120 by controlling the set of laser tuning signals 121 which may be used to control tuning of the set of tunable elements 125 of the tunable laser 120. The set of analog functions 140 has a set of tunable parameters associated therewith which may be controlled to support tuning of the wavelength of the laser output 129 of the tunable laser 120 (e.g., controlled via the fast feedback loop 160 based on direct analog feedback from the wavemeter 130, controlled via the slow feedback loop 170 based on feedback from the controller 150, or the like, as well as various combinations thereof). The set of analog functions 140 may include various analog functions which may be configured to control tuning of the wavelength of the laser output 129 of the tunable laser 120. For example, the set of analog functions 140 may include relatively simple analog functions, one or more complex analog functions, or the like, as well as various combinations thereof. For example, the set of analog functions 140 may include linear analog functions, non-linear analog functions, or the like, as well as various combinations thereof. For example, the set of analog functions may include subtraction elements, addition elements, matrices, amplifiers, squaring elements, or the like, as well as various combinations thereof.

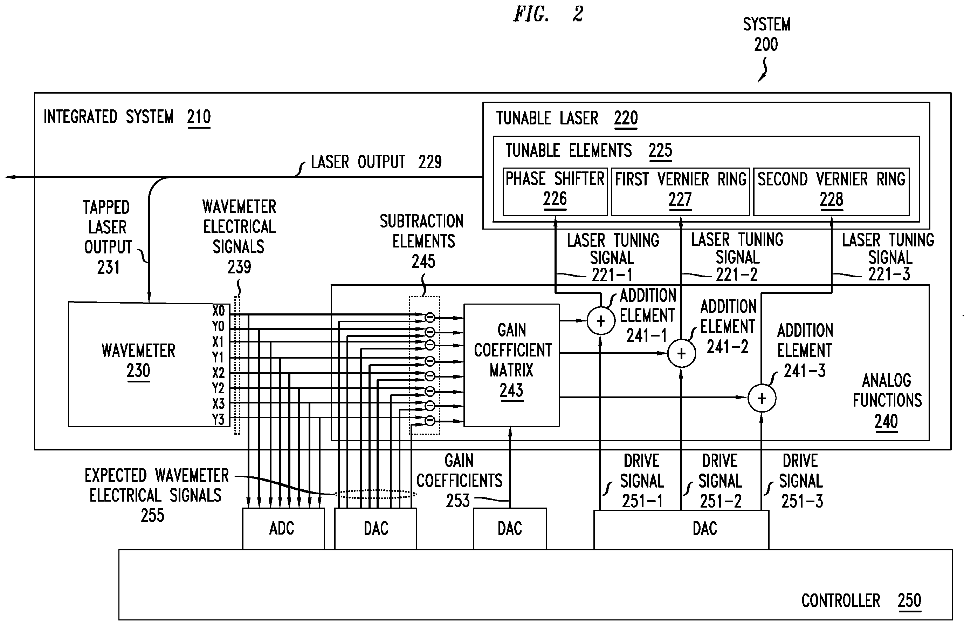

In one example, an example embodiment of which is presented with respect to FIG. 2, the set of tunable parameters supported by the set of analog functions 140 may include a set of drive signals (e.g., which may be used as the basis for the tunable laser signals 121 for the tunable elements 125 of the tunable laser 120), a set of gain coefficients (e.g., which may be used to control the drive signals to provide the tunable laser signals 121 for the tunable elements 125 of the tunable laser 120), a set of expected wavemeter electrical signals (e.g., which may be used to control the gain coefficients which may be used to control the drive signals to provide the tunable laser signals 121 for the tunable elements 125 of the tunable laser 120), or the like, as well as various combinations thereof. Here, the set of analog functions 140 may include a set of subtraction elements (e.g., for measuring error differences between actual and expected wavemeter electrical signals of the wavemeter 130), a gain coefficient matrix (e.g., for maintaining gain coefficients which may control gain of the drive signals driving the tunable laser 120), and a set of addition elements (e.g., for applying the gain coefficients to the drive signals to produce the laser control signals that drive the tunable laser 120).

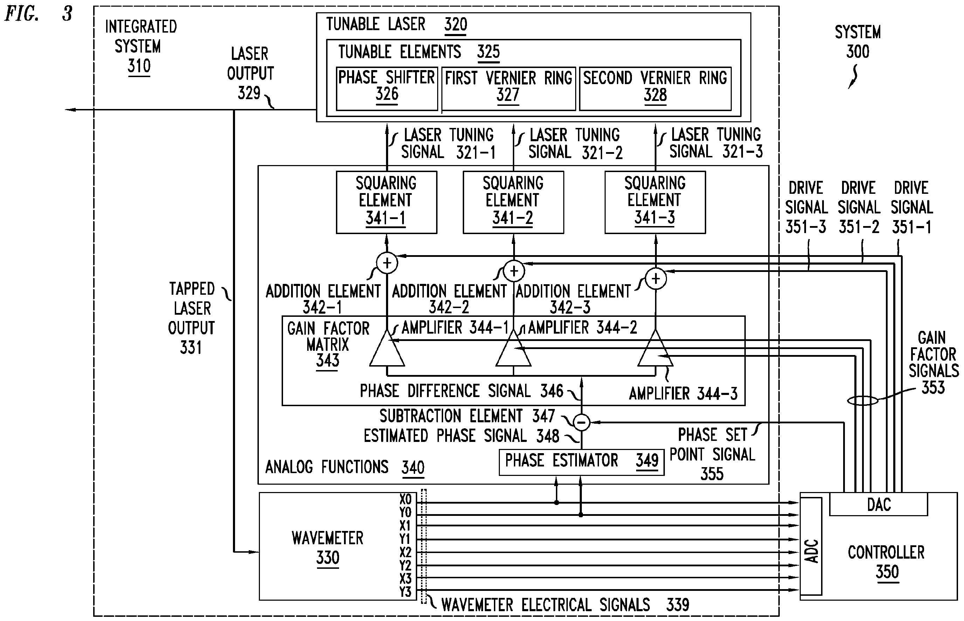

In one example, an example embodiment of which is presented with respect to FIG. 3, the set of tunable parameters supported by the set of analog functions 140 may include a set of drive signals (e.g., which may be used as the basis for the tunable laser signals 121 for the tunable elements 125 of the tunable laser 120), a set of gain factor signals (e.g., which may be used to control the drive signals to provide the tunable laser signals 121 for the tunable elements 125 of the tunable laser 120), and a phase set point signal (e.g., which may be used, in combination with a phase estimator output generated based on outputs of the wavemeter 130, to control a gain factor matrix configured to control the drive signals and, thus, the tunable laser signals 121). Here, the set of analog functions 140 may include a phase estimator (e.g., for determining an estimated phase based on wavemeter electrical signals), a subtraction element (e.g., for determining the difference between the estimated phase determined by the phase estimator based on the wavemeter electrical signals and the phase set point signal output by the controller 150), a gain factor matrix (e.g., for controlling gain factor signals to provide modified gain factor control signals which may control gain of the drive signals driving the tunable laser 120), a set of addition elements (e.g., for applying the modified gain factor control signals to the drive signals to produce modified drive signals that drive the tunable laser 120), and a set of squaring elements (e.g., which may be used to further control the modified drive signals to provide the tunable laser signals 121 for the tunable elements 125 of the tunable laser 120).

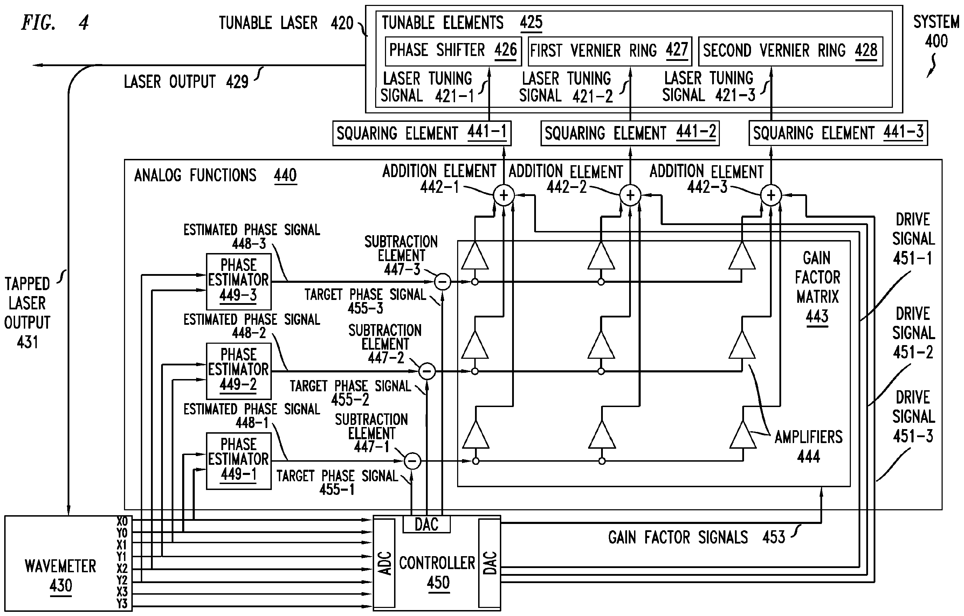

In one example, an example embodiment of which is presented with respect to FIG. 4, the set of tunable parameters supported by the set of analog functions 140 may include a set of drive signals (e.g., which may be used as the basis for the tunable laser signals 121 for the tunable elements 125 of the tunable laser 120), a set of gain factor signals (e.g., which may be used to control the drive signals to provide the tunable laser signals 121 for the tunable elements 125 of the tunable laser 120), and a set of target phase signals (e.g., which may be used, in combination with a set of phase estimator outputs generated based on outputs of the wavemeter 130, to control a gain factor matrix configured to control the drive signals and, thus, the tunable laser signals 121). Here, the set of analog functions 140 may include a set of phase estimators (e.g., for determining estimated phases based on wavemeter electrical signals), a set of subtraction elements (e.g., for determining the differences between the estimated phases determined by the phase estimators based on the wavemeter electrical signals and the target phases output by the controller 150), a gain factor matrix (e.g., for controlling gain factor signals to provide modified gain factor control signals which may control gain of the drive signals driving the tunable laser 120), a set of addition elements (e.g., for applying the modified gain factor control signals to the drive signals to produce modified drive signals that drive the tunable laser 120), and a set of squaring elements (e.g., which may be used to further control the modified drive signals to provide the tunable laser signals 121 for the tunable elements 125 of the tunable laser 120).

It will be appreciated that the set of analog functions 140 may include various other types of analog functions, which may have various other sets of tunable parameters associated therewith, which may be used to support tuning of the wavelength of the laser output 129 of the tunable laser 120 by controlling the set of laser tuning signals 121 which may be used to control tuning of the set of tunable elements 125 of the tunable laser 120.

It is noted that references herein to the set of analog functions 140 or other related sets of analog functions may be read more generally as being references to means for performing analog operations, such that the means for performing analog operations as discussed herein may be the set of analog functions (or other similar sets of analog functions presented herein) and/or other suitable means and associated equivalents for performing analog operations in accordance with various example embodiments presented herein.

The controller 150 is configured to support tuning of the wavelength of the laser output 129 of the tunable laser 120. The controller 150 is configured to support slow path tuning of the wavelength of the laser output 129 of the tunable laser 120. The controller 150 may support tuning of the wavelength of the laser output 129 of the tunable laser 120 by controlling the set of laser tuning signals 121 which may be used to control tuning of the set of tunable elements 125 of the tunable laser 120. The controller 150 may control the set of laser tuning signals 121, which may be used to control tuning of the set of tunable elements 125 of the tunable laser 120, by controlling the set of tunable parameters supported by the set of analog functions 140. It will be appreciated that the controller 150 may support various other control functions which may be used to support tuning of the wavelength of the laser output 129 of the tunable laser 120 by controlling the set of laser tuning signals 121 which may be used to control tuning of the set of tunable elements 125 of the tunable laser 120. The controller 150 may be a computer, a microcontroller, or any other suitable control element.

The fast feedback loop 160 and the slow feedback loop 170 are configured to control tuning of the tunable laser 120. The fast feedback loop 160 and the slow feedback loop 170 are configured to control tuning of the tunable laser 120 by controlling tuning of the tunable elements 125 of the tunable laser 120. The fast feedback loop 160 and the slow feedback loop 170 are configured to control tuning of the tunable laser 120 by controlling tuning of the tunable elements 125 of the tunable laser 120 based on control of the laser tuning signals 121. The set of analog functions 140 has a set of tunable parameters associated therewith, which may be used to control tuning of the laser tuning signals 121 for controlling tuning of the tunable laser 120. The set of analog functions 140 may be configured to control tuning of the tunable laser 120, based on the set of tunable parameters associated with the set of analog functions 140, by using direct analog feedback from the wavemeter 130 to the set of analog functions 140 based on the fast feedback loop 160 for performing fast tuning of the tunable laser 120 and by using feedback from the controller 150 to the set of analog functions 140 based on the slow feedback loop 170 for performing slow tuning of the tunable laser 120. The fast tuning of the tunable laser 120 may be based on use of the direct analog feedback from the wavemeter 130 to the set of analog functions 140 based on the fast feedback loop 160 and the set of tunable parameters of the set of analog functions 140. The slow tuning of the tunable laser 120 may be based on control over the set of tunable parameters of the set of analog functions 140 by the controller 150 based on feedback from the wavemeter 130 to the controller 150. In other words, the set of analog functions 140 supports fast tuning of the tunable laser 120 based on direct analog feedback from the wavemeter 130 to the set of analog functions 140 based on the fast feedback loop 160 using the set of tunable parameters of the set of analog functions 140 where the set of tunable parameters of the set of analog functions 140 may be determined based on more complex calibration capabilities of the controller 150 that operate based on the slow feedback loop 170 using feedback from the wavemeter 130. As a result, the fast feedback loop 160 may be agnostic to the complex "transfer function" between the wavemeter 130 and the tunable laser 120, with the exception of some local derivatives which may be computed by the controller 150 based on slower digital processing. It will be appreciated that, since tuning of the tunable laser 120 is based on the laser output 129 of the tunable laser 120, the fast feedback loop 160 and the slow feedback loop 170 each may be complete loops from the laser output 129 of the tunable laser 120 back to the tunable elements 125 of the tunable laser 120; however, for purposes of clarity in describing various example embodiments, only portions of the fast feedback loop 160 and the slow feedback loop 170 from the output of the wavemeter 130 to the tunable elements 125 of the tunable laser 120 are depicted. The operation of the fast feedback loop 160 and the slow feedback loop 170 in supporting tuning of the tunable laser 120 is discussed further below.

The fast feedback loop 160 is configured to control tuning of the tunable laser 120. The fast feedback loop 160 is configured to control tuning of the tunable laser 120 by controlling the laser tuning signals 121 to control tuning of the tunable elements 125 of the tunable laser 120. The fast feedback loop 160 supports direct analog feedback from the wavemeter 130 to the tunable laser 120. The fast feedback loop 160 includes a path from the wavemeter 130 to the set of analog functions 140 to the tunable laser 120. The set of analog functions 140 has a set of tunable parameters associated therewith, which may be used to control tuning of the tunable laser 120. The set of analog functions 140 may be configured to control tuning of the tunable laser 120 based on the set of tunable parameters associated with the set of analog functions 140 and the direct analog feedback from the wavemeter 130 to the set of analog functions 140. The set of tunable parameters associated with the set of analog functions 140 may be controlled by the controller 150 based on the slow feedback loop 170. The fast feedback loop 160 enables correction of faster and smaller fluctuations and changes in the output wavelength of the laser output 129 (e.g., high-frequency fluctuations with relatively small amplitude, such as technical noise, or other fluctuations) based on use of the direct analog feedback to control the laser tuning signals 121 to control tuning of the tunable elements 125 of the tunable laser 120. It is noted that direct analog feedback from the wavemeter 130 to the tunable laser 120 may support stabilization of faster laser fluctuations which might otherwise not be able to be controlled where a high precision wavemeter having a complex multi-channel sine-shaped response as a function of wavelength is used to tune an integrated tunable laser that needs multi-channel ramp-shaped electrical signals in order to linearly sweep wavelength and processing of the signal to apply to the laser control as a function of the signal generated by the wavemeter generally requires complex processing that can take too much time to stabilize the faster laser fluctuations.

The slow feedback loop 170 is configured to control tuning of the tunable laser 120. The slow feedback loop 170 is configured to control tuning of the tunable laser 120 by controlling the laser tuning signals 121 to control tuning of the tunable elements 125 of the tunable laser 120. The slow feedback loop 170 is configured to control tuning of the tunable laser 120 by controlling a set of tunable parameters of the set of analog functions 140 to control the laser tuning signals 121 to control tuning of the tunable elements 125 of the tunable laser 120. The fast feedback loop 160 includes a path from the wavemeter 130 to the controller 150 to the set of analog functions 140. The slow feedback loop 170 enables correction of slower and larger fluctuations or changes in the output wavelength of the laser output 129 (e.g., based on temperature changes or other causes of such drift), provided such changes are slow enough, based on adjustment of the set of tunable parameters of the set of analog functions 140 to control the laser tuning signals to control tuning of the tunable elements 125 of the tunable laser 120.

It will be appreciated that various configurations of the system 100, for supporting tuning of tunable lasers, may be supported. Example configurations of the system 100 of FIG. 1 are presented with respect to FIG. 2, FIG. 3, and FIG. 4.

FIG. 2 depicts an example embodiment of a system configured to support stabilization of a tunable laser. It will be appreciated that the system 200 of FIG. 2 is based on the system 100 of FIG. 1.

In FIG. 2, the system 200 includes an integrated system 210 and a controller 250, corresponding to the integrated system 110 and the controller 150 of FIG. 1, respectively. The integrated system 210 includes a tunable laser 220, a wavemeter 230, and a set of analog functions 240, corresponding to the tunable laser 120, the wavemeter 130, and the set of analog functions 140 of FIG. 1, respectively. The controller 250 is configured to provide various control functions for the integrated system 210, including supporting tuning of the tunable laser 220. It will be appreciated that, since the integrated system 210 operates in the analog domain and the controller 250 operates in the digital domain, a set of conversion elements may be used to support exchange of information between the integrated system 210 and the controller 250 (e.g., ADCs may be used for sending information from the integrated system 210 to the controller 250 and DACs may be used for sending information from the controller 250 to the integrated system 210).

In FIG. 2, the tunable laser 220 produces a laser output 229. The laser output 229 is output by the integrated system 210. The laser output 229 has a wavelength which may be tuned for the tunable laser 220. The tunable laser 220 includes a set of tunable elements 225 including a phase shifter 226, a first Vernier ring 227, and a second Vernier ring 228. The wavelength of the tunable laser 220 is controlled by three laser tuning signals 221-1 to 221-3 (collectively, laser tuning signals 221) which control the phase shifter 226, the first Vernier ring 227, and the second Vernier ring 228, respectively. The phase shifter 226, the first Vernier ring 227, and the second Vernier ring 228 may be considered to have tunable laser parameters associated therewith, respectively, where the values of the tunable laser parameters that control the phase shifter 226, the first Vernier ring 227, and the second Vernier ring 228 may be controlled by the three laser tuning signals 221-1 to 221-3, respectively. The laser tuning signals 221 which control tuning of the tunable elements 225 for controlling tuning of the tunable laser 220 are generated based on a fast feedback loop from the wavemeter 230 to the set of analog functions 240 (based on a set of tunable parameters supported by the set of analog functions 240) and based on a slow feedback loop controlled by the controller 250 (which controls tuning of the set of tunable parameters of the supported by the set of analog functions 240). Here, as discussed further below, the set of tunable parameters supported by the set of analog functions 240 and tuned by the controller 250 includes drive signals, gain coefficients, and expected wavemeter electrical signals. It will be appreciated that, although primarily presented with respect to example embodiments in which specific numbers and types of tunable elements 225 are used for tuning the tunable laser 220, fewer or more tunable elements 225 may be used for tuning the tunable laser 220 (e.g., two elements, four elements, or the like), other types of tunable elements 225 may be used for tuning the tunable laser 220 (e.g., filters, gratings, or the like), or the like, as well as various combinations thereof.

In FIG. 2, the wavemeter 230 is configured to tap a portion of the laser output 229 (denoted as tapped laser output 231), measure the tapped laser output 231, and produce a set of wavemeter electrical signals 239 based on the measurement of the tapped laser output 231. In the example of FIG. 2, although the details are omitted for purposes of clarity, the wavemeter 230 includes four interferometers which produce four pairs of I/Q outputs (illustratively, a first interferometer produces a first pair of I/Q outputs respectively labeled as X0/Y0, a second interferometer produces a second pair of I/Q outputs respectively labeled as X1/Y1, a third interferometer produces a third pair of I/Q outputs respectively labeled as X2/Y2, and a fourth a interferometer produces a fourth pair of I/Q outputs respectively labeled as X3/Y3) that form the wavemeter electrical signals 239-1 - 239-8, respectively, that are output by the wavemeter 230. It will be appreciated that, although primarily presented with respect to an example in which the wavemeter 230 includes four interferometers having four pairs of I/Q outputs, the wavemeter 230 may include fewer or more interferometers providing fewer or more pairs of I/Q outputs. It will be appreciated that, although omitted for purposes of clarity, the wavemeter 230 also may include a stable wavelength reference. The wavemeter electrical signals 239 are provided to the set of analog functions 240 (as part of a fast feedback loop that provides direct analog feedback for controlling the wavelength of the laser output 229 based on the set of tunable parameters associated with the set of analog functions 240) and to the controller 250 (as part of a slow feedback loop that enables the controller 250 to control the set of tunable parameters associated with the set of analog functions 240).

In FIG. 2, the set of analog functions 240 includes a set of addition elements 241-1 - 241-3 (collectively, addition elements 241), a gain coefficient matrix 243, and a set of subtraction elements 245-1 - 245-8 (collectively, subtraction elements 245). The set of tunable parameters associated with the set of analog functions 240 and controlled by the controller 250 includes a set of drive signals 251-1 - 251-3 (collectively, drive signals 251), a set of gain coefficients 253, and a set of expected wavemeter electrical signals 255-1 - 255-8 (collectively, expected wavemeter electrical signals 255). The drive signals 251 are provided to the addition elements 241 (illustratively, drive signals 251-1 to 251-3 are provided to addition elements 241-1 to 241-3, respectively). The gain coefficients 253 includes gain coefficient values provided to the gain coefficient matrix 243. The expected wavemeter electrical signals 255 are provided to the subtraction elements 245 (illustratively, expected wavemeter electrical signals 255-1 to 255-8 are provided to subtraction elements 245-1 to 245-8, respectively).

In FIG. 2, the addition elements 241 have three inputs connected to the controller 250 for receiving the three drive signals 251, three inputs connected to the three outputs of the gain coefficient matrix 243, and three outputs connected to the phase shifter 226, the first Vernier ring 227, and the second Vernier ring 228 for providing the three laser tuning signals 221 to the phase shifter 226, the first Vernier ring 227, and the second Vernier ring 228, respectively. The addition elements 241, based on addition of the three drive signals 251 from the controller 250 and the three outputs of the gain coefficient matrix 243, produce the three laser tuning signals 221 which control the phase shifter 226 (e.g., to control the phase of the laser output 229 of the tunable laser 220), the first Vernier ring 227, and the second Vernier ring 228, respectively. It will be appreciated that, in this arrangement, the three laser tuning signals 221 which control the phase shifter 226, the first Vernier ring 227, and the second Vernier ring 228, respectively, may be considered to be modified versions of the drive signals 251 from the controller 250 and, thus, also may be considered to be (and, thus, also referred to as) drive signals. The laser tuning signals 221 (and, thus, the three drive signals 251 from the controller 250 and the three outputs of the gain coefficient matrix 243) may be any types of signals suitable for controlling the phase shifter 226, the first Vernier ring 227, and the second Vernier ring 228, respectively (e.g., voltages, currents, or the like, as well as various combinations thereof).

In FIG. 2, the gain coefficient matrix 243 has eight inputs connected to eight outputs of the subtraction elements 245 for receiving the eight output signals of the subtraction elements 245, one input connected to the controller 250 for receiving the set of gain coefficients 253, and three outputs connected to the three addition elements 241. The gain coefficient matrix 243, based on the gain coefficients 253 from the controller 250 and the outputs of the subtraction elements 245, produce the three output signals from the gain coefficient matrix 243 that are input to the addition elements 241 for producing the three laser tuning signals 221 which control the phase shifter 226, the first Vernier ring 227, and the second Vernier ring 228, respectively. The gain coefficient matrix 243 may produce the three output signals, which are input to the addition elements 241 for producing the three laser tuning signals 221, by amplifying the difference signals from the subtraction elements 245 by the gain coefficients provided by the controller 250.

In FIG. 2, the subtraction elements 245 have eight inputs connected to eight outputs of the wavemeter 230 for receiving the eight wavemeter electrical signals 239, eight inputs connected to the controller 250 for receiving the eight expected wavemeter electrical signals 255, and eight outputs connected to the eight inputs of the gain coefficient matrix 243. The subtraction elements 245, based on subtraction of the expected wavemeter electrical signals 255 from the controller and the wavemeter electrical signals 239 from the wavemeter 230, produce the eight output signals of the subtraction elements 245 that are input to the gain coefficient matrix 243 to produce the three output signals from the gain coefficient matrix 243 that are input to the addition elements 241 for producing the three laser tuning signals 221 which control the phase shifter 226, the first Vernier ring 227, and the second Vernier ring 228, respectively.

In FIG. 2, as discussed above, the tunable elements 225 of the tunable laser 220 may be controlled based on drive signals 251. In order to further understand the operation of the system 200 of FIG. 2, consider an example in which the drive signals 251 are implemented as drive currents (e.g., as opposed to voltages or other types of signals suitable for controlling the phase shifter 226, the first Vernier ring 227, and the second Vernier ring 228). In this example, assume that the drive signals 251 output by the controller 250 are based on set point values which may be modified by the set of analog functions 240 based on the fast feedback loop (e.g., based on the wavemeter electrical signals 239 received by the set of analog functions 240 from the wavemeter 230) and based on the slow feedback loop (e.g., based on feedback determined by the controller 250 based on the wavemeter electrical signals 239 received by the controller 250 from the wavemeter 230 and provided from the controller 250 to the set of analog functions 240). For example, assume that the set point values of the three drive signals 251-1, 251-2, and 251-3 from the controller 250 are currents of 1 milliamp (mA), 3mA, and 1.5mA, respectively. The addition elements 241-1, 241-2, and 241-3 may modify these set points of the three drive signals 251-1, 251-2, and 251-3 from the controller 250, based on the outputs of the gain coefficient matrix 243, to provide the laser tuning signals 221-1, 221-2, and 221-3 that are applied to control the phase shifter 226, the first Vernier ring 227, and the second Vernier ring 228, respectively. For example, assume that the gain coefficients of the gain coefficient matrix cause the set point values of the three drive signals 251-1, 251-2, and 251-3 to be changed from 1mA, 3mA, and 1.5 elements 225 may include fast path modulation by the set of analog functions 240 based on the wavemeter eletrical signals 239 from the wavemeter 230 and slow path modulation by the set of analog functions 240 based on the feedback determined by the controller 250 based on the wavemeter eletrical signals 239 from the wavemeter 230.

FIG. 3 depicts an example embodiment of a system configured to support stabilization of a tunable laser.

In FIG. 3, the system 300 includes an integrated system 310 and a controller 350, corresponding to the integrated system 110 and the controller 150 of FIG. 1, respectively. The integrated system 310 includes a tunable laser 320, a wavemeter 330, and a set of analog functions 340, corresponding to the tunable laser 120, the wavemeter 130, and the set of analog functions 140 of FIG. 1, respectively. The controller 350 is configured to provide various control functions for the integrated system 310, including supporting tuning of the tunable laser 320. It will be appreciated that, since the integrated system 310 operates in the analog domain and the controller 350 operates in the digital domain, a set of conversion elements may be used to support exchange of information between the integrated system 310 and the controller 350 (e.g., ADCs may be used for sending information from the integrated system 310 to the controller 350 and DACs may be used for sending information from the controller 350 to the integrated system 310).

In FIG. 3, the tunable laser 320 produces a laser output 329. The laser output 329 is output by the integrated system 310. The laser output 329 has a wavelength which may be tuned for the tunable laser 320. The tunable laser 320 includes a set of tunable elements 325 including a phase shifter 326, a first Vernier ring 327, and a second Vernier ring 328. The wavelength of the tunable laser 320 is controlled by three laser tuning signals 321-1 to 321-3 (collectively, laser tuning signals 321) which control the phase shifter 326, the first Vernier ring 327, and the second Vernier ring 328, respectively. The phase shifter 326, the first Vernier ring 327, and the second Vernier ring 328 may be considered to have tunable laser parameters associated therewith, respectively, where the values of the tunable laser parameters that control the phase shifter 326, the first Vernier ring 327, and the second Vernier ring 328 may be controlled by the three laser tuning signals 321-1 to 321-3, respectively. The laser tuning signals 321 which control tuning of the tunable elements 325 for controlling tuning of the tunable laser 320 are generated based on a fast feedback loop from the wavemeter 330 to the set of analog functions 340 (based on a set of tunable parameters supported by the set of analog functions 340) and based on a slow feedback loop controlled by the controller 350 (which controls tuning of the set of tunable parameters of the supported by the set of analog functions 340). Here, as discussed further below, the set of tunable parameters supported by the set of analog functions 340 and tuned by the controller 350 includes drive signals, gain factor signals, and a phase set point signal. It will be appreciated that, although primarily presented with respect to example embodiments in which specific numbers and types of tunable elements 325 are used for tuning the tunable laser 320, fewer or more tunable elements 325 may be used for tuning the tunable laser 320 (e.g., two elements, four elements, or the like), other types of tunable elements 325 may be used for tuning the tunable laser 320 (e.g., filters, gratings, or the like), or the like, as well as various combinations thereof.

In FIG. 3, the wavemeter 330 is configured to tap a portion of the laser output 329 (denoted as tapped laser output 331), measure the tapped laser output 331, and produce a set of wavemeter electrical signals 339 based on the measurement of the tapped laser output 331. In the example of FIG. 3, although the details are omitted for purposes of clarity, the wavemeter 330 includes four interferometers which produce four pairs of I/Q outputs (illustratively, a first interferometer produces a first pair of I/Q outputs respectively labeled as X0/Y0, a second interferometer produces a second pair of I/Q outputs respectively labeled as X1/Y1, a third interferometer produces a third pair of I/Q outputs respectively labeled as X2/Y2, and a fourth a interferometer produces a fourth pair of I/Q outputs respectively labeled as X3/Y3) that form the wavemeter electrical signals 339-1 - 339-8, respectively, that are output by the wavemeter 330. It will be appreciated that, although primarily presented with respect to an example in which the wavemeter 330 includes four interferometers having four pairs of I/Q outputs, the wavemeter 330 may include fewer or more interferometers providing fewer or more pairs of I/Q outputs. A portion of the wavemeter electrical signals 339 are provided to the set of analog functions 340 (as part of a fast feedback loop that provides direct analog feedback for controlling the wavelength of the laser output 329 based on the set of tunable parameters associated with the set of analog functions 340) and to the controller 350 (as part of a slow feedback loop that enables the controller 350 to control the set of tunable parameters associated with the set of analog functions 340).

In FIG. 3, the set of analog functions 340 includes a set of squaring elements 341-1 - 341-3 (collectively, squaring elements 341), a set of addition element 342-1 - 342-3 (collectively, addition element 342), a gain factor matrix 343 including a set of amplifiers 344-1 - 344-3 (collectively, amplifiers 344), a subtraction element 347, and a phase estimator 349. The set of tunable parameters associated with the set of analog functions 340 and controlled by the controller 350 includes a set of drive signals 351-1 - 351-3 (collectively, drive signals 351), a set of gain factor signals 353-1 - 353-3 (collectively, gain factor signals 353), and a phase set point signal 355. The drive signals 351 are provided to the addition elements 341 (illustratively, drive signals 351-1 to 351-3 are provided to addition elements 341-1 to 341-3, respectively). The gain factor signals 353 are provided to the gain factor matrix 343 (illustratively, gain factor signals 353-1 to 353-3 are provided to amplifiers 344-1 to 344-3 of the gain factor matrix 343, respectively). The phase set point signal 355 is provided to the subtraction element 347 for comparison with the estimated phase determined by the phase estimator 349.

In FIG. 3, the squaring elements 341 have three inputs connected to three outputs of the addition elements 342 and three outputs connected to the phase shifter 326, the first Vernier ring 327, and the second Vernier ring 328 for providing the three laser tuning signals 321 to the phase shifter 326, the first Vernier ring 327, and the second Vernier ring 328, respectively. The squaring elements 341, based on processing of the three modified drive signals output by the three addition elements 342, produce the three laser tuning signals 321 which control the phase shifter 326 (e.g., to control the phase of the laser output 329 of the tunable laser 320), the first Vernier ring 327, and the second Vernier ring 328, respectively. It will be appreciated that, in this arrangement, the three laser tuning signals 321 which control the phase shifter 326, the first Vernier ring 327, and the second Vernier ring 328, respectively, may be considered to be modified versions of the drive signals 351 from the controller 350 and, thus, also may be considered to be (and, thus, also referred to as) drive signals. The laser tuning signals 321 (and, thus, the three drive signals 351 from the controller 350 and the three outputs of the gain factor matrix 343) may be any types of signals suitable for controlling the phase shifter 326, the first Vernier ring 327, and the second Vernier ring 328, respectively (e.g., voltages, currents, or the like, as well as various combinations thereof).

In FIG. 3, the addition elements 342 have three inputs connected to the controller 350 for receiving the three drive signals 351, three inputs connected to the three outputs of the gain factor matrix 343 for receiving the three outputs of the three amplifiers 344 of the gain factor matrix 343, and three outputs connected to the three inputs of the squaring elements 341 for providing the modified drive signals to the squaring elements 341, respectively. The addition elements 342, based on addition of the three drive signals 351 from the controller 350 and the three outputs of the three amplifiers 344 of the gain coefficient matrix 343, produce the three modified drive signals which are provided to the three squaring elements 341 for producing the three laser tuning signals 321 which control the phase shifter 326 (e.g., to control the phase of the laser output 329 of the tunable laser 220), the first Vernier ring 327, and the second Vernier ring 328, respectively. It will be appreciated that, in this arrangement, the three modified drive signals which are used to generate the laser tuning signals 321 which control the phase shifter 326, the first Vernier ring 327, and the second Vernier ring 328, respectively, are modified versions of the drive signals 351 from the controller 350 and, thus, also may be considered to be (and, thus, also referred to as) drive signals. The modified drive signals provided by the addition elements 342 (and, thus, the three drive signals 351 from the controller 350 and the three outputs of the three amplifiers 344 of the gain factor matrix 343) may be any types of signals suitable for controlling the phase shifter 326, the first Vernier ring 327, and the second Vernier ring 328, respectively (e.g., voltages, currents, or the like, as well as various combinations thereof).

In FIG. 3, the gain factor matrix 343 has three inputs (to the three amplifiers 344 of the gain factor matrix 343) connected to the output of the subtraction element 347 for receiving the output signal of the subtraction element 347, three inputs (to the three amplifiers 344 of the gain factor matrix 343) connected to the controller 350 for receiving the gain factor signals 353, and three outputs (from the three amplifiers 344 of the gain factor matrix 343) connected to three inputs of the three addition elements 342. The amplifiers 344 of the gain factor matrix 343, based on the gain factor signals 353 from the controller 350 and the output of the subtraction element 347, produce the three output signals from the three amplifiers 344 of the gain factor matrix 343 that are input to the addition elements 342 for controlling the three drive signals 351 from the controller 350 and, thus, producing the three laser tuning signals 321 which control the phase shifter 326, the first Vernier ring 327, and the second Vernier ring 328, respectively. The gain factor matrix 343 may produce the three output signals, which are input to the addition elements 342 for controlling the three drive signals 351 that are used to produce the three laser tuning signals 321, by modifying the gain factor signals 353 provided by the controller 350 based on a phase difference signal 346 from the subtraction element 347.

In FIG. 3, the subtraction element 347 has one input connected to the output of the phase estimator 349 for receiving the estimated phase signal 348 from the phase estimator 349, one input connected to the controller 350 for receiving the phase set point signal 355 from the controller 350, and one output connected to the gain factor matrix 343 for providing the phase difference signal 346 to the amplifiers 344 of the gain factor matrix 343. The subtraction element 347, based on subtraction of the phase set point signal 355 from the controller 350 and the estimated phase signal 348 generated based on a portion of the wavemeter electrical signals 339 provided by the wavemeter 330, produces the phase difference signal 346 provided to the amplifiers 344 of the gain factor matrix 343 for controlling the output signals which are provided to the addition elements 342 for modifying the drive signals 351 to produce the three laser tuning signals 321 which control the phase shifter 326, the first Vernier ring 327, and the second Vernier ring 328, respectively. If there is no phase error, then the estimated phase signal 348 generated based on a portion of the wavemeter electrical signals 339 provided by the wavemeter 330 and the phase set point signal 355 from the controller 350 will be equal (i.e., the phase difference signal 346 will be zero), such that there is no adjustment by the gain factor matrix 343 to the gain factor signals 353 from the controller 350 that are used to produce the output signals which are provided to the addition elements 342 for modifying the drive signals 351 to produce the three laser tuning signals 321 which control the phase shifter 326, the first Vernier ring 327, and the second Vernier ring 328, respectively. If there is phase error, then the estimated phase signal 348 generated based on a portion of the wavemeter electrical signals 339 provided by the wavemeter 330 and the phase set point signal 355 from the controller 350 will not be equal (i.e., the phase difference signal 346 will be non-zero), such that there will be some adjustment by the gain factor matrix 343 to the gain factor signals 353 from the controller 350 that are used to produce the output signals which are provided to the addition elements 342 for modifying the drive signals 351 to produce the three laser tuning signals 321 which control the phase shifter 326, the first Vernier ring 327, and the second Vernier ring 328, respectively.

In FIG. 3, the phase estimator 349 has two inputs connected to two of the wavemeter electrical signals 339 from the wavemeter 330 (namely, X0 and X1) and one output connected to an input of the subtraction element 347 for providing the estimated phase signal 348 to the subtraction element 347 for use in generating the phase difference signal 346 that is provided to the amplifiers 344 of the gain factor matrix 343. The phase estimator 349, based on the two wavemeter electrical signals 339 from the wavemeter 330 (namely, X0 and X1), produces the estimated phase signal 348 that is provided to the subtraction element 347 for use in generating the phase difference signal 346 that is provided to the amplifiers 344 of the gain factor matrix 343, such that the estimated phase signal 348 is produced in the analog domain directly from the output of the wavemeter 330 as opposed to being produced based on processing by the controller 350. It will be appreciated that, although primarily presented with respect to use of two of the eight wavemeter electrical signals 339 from the wavemeter 330 to produce the estimated phase signal 348, the estimated phase signal 348 may be produced by the phase estimator 349 using fewer or more of the wavemeter electrical signals 339 from the wavemeter 330.

In FIG. 3, as discussed above, the tunable elements 325 of the tunable laser 320 may be controlled based on the drive signals 351, the gain factor signals 353, and phase set point signal 355. In order to further understand the operation of the system 300 of FIG. 3, consider an example in which the drive signals 351 are implemented as drive voltages (e.g., as opposed to currents or other types of signals suitable for controlling the phase shifter 326, the first Vernier ring 327, and the second Vernier ring 328), the gain factor signals 353 are implemented as voltages (e.g., as opposed to current or other type of signals), and the phase set point signal 355 is implemented as a voltage (e.g., as opposed to current or other type of signals). In this example, assume that the drive signals 351 output by the controller 350 are based on set point values which may be modified by the set of analog functions 340 based on the fast feedback loop (e.g., based on the wavemeter electrical signals 339 received by the set of analog functions 340 from the wavemeter 330) and based on the slow feedback loop (e.g., based on feedback determined by the controller 350 based on the wavemeter electrical signals 339 received by the controller 350 from the wavemeter330 and provided from the controller 350 to the set of analog functions 340). For example, assume that the set point values of the three drive signals 353-1, 353-2, and 353-3 from the controller 350 are voltages of 0.6 volts (V), 1.2V, and 1.1V, respectively. The addition elements 342-1, 342-2, and 342-3 may modify these set points of the three drive signals 351-1, 351-2, and 351-3 from the controller 350, based on the outputs of the gain factor matrix 343, to provide the laser tuning signals 321-1, 321-2, and 321-3 that are applied to control the phase shifter 326, the first Vernier ring 327, and the second Vernier ring 328, respectively. For example, assume that the gain factors of the gain factor matrix cause the set point values of the three drive signals 351-1, 351-2, and 351-3 to be changed from 0.6V, 1.2V, and 1.1V to 0.64V, 1.04V, and 1.17V, respectively. In this manner, the modulation of the drive signals 351 to provide the laser tuning signals 321 that are used to tune the tunable elements 325 may include fast path modulation by the set of analog functions 340 based on the wavemeter eletrical signals 339 from the wavemeter 330 and slow path modulation by the set of analog functions 340 based on the feedback determined by the controller 350 based on the wavemeter eletrical signals 339 from the wavemeter 330.

In FIG. 3, as discussed above, the wavelength $\lambda$ of the laser output 329 of the tunable laser 320 depends on three parameters of the tunable laser 320 (namely, the current or voltage applied to the phase shifter 326, the first Vernier ring 327, and the second Vernier ring 328, respectively), which may be referrred to as parameters $s_1$, $s_2$, and $s_3$, respectively. The wavelength $\lambda$ of the laser output 329 of the tunable laser 320 can be optimized by the error signal determined from the wavemeter 330 (which may be denoted as $\lambda(s_1, s_2, s_3)$ to indicate that the wavelength $\lambda$ of the laser output 329 of the tunable laser 320 is optimized by the set of laser parameters $(s_1, s_2, s_3)$). The local partial derivatives $\frac{d\lambda}{ds_1}$, $\frac{d\lambda}{ds_2}$, and $\frac{d\lambda}{ds_3}$ may be used in providing feedback to counteract the error (and may be adjusted by a gain coefficient to ensure stable or efficient feedback control). For a measured deviation $d\lambda0$, the values $ds_1$, $ds_2$, $ds_3$ may be determined by :

$$ds\_1 = \{d\lambda0\}/\{\frac{d\lambda}{ds_1}\}, ds\_2 = \{d\lambda0\}/\{\frac{d\lambda}{ds_2}\}, ds\_3 = \{d\lambda0\}/\{\frac{d\lambda}{ds_3}\}$$

, and then the values $ds_1$, $ds_2$, $ds_3$ may be applied to the appropriate portions of the tunable laser 320 for conrolling the wavelength of the laser output 329 of the tunable laser 320.

FIG. 4 depicts an example embodiment of a system configured to support stabilization of a tunable laser.

In FIG. 4, the system 400 includes an integrated system 410 and a controller 450, corresponding to the integrated system 110 and the controller 150 of FIG. 1, respectively. The integrated system 410 includes a tunable laser 420, a wavemeter 430, and a set of analog functions 440, corresponding to the tunable laser 120, the wavemeter 130, and the set of analog functions 140 of FIG. 1, respectively. The controller 450 is configured to provide various control functions for the integrated system 410, including supporting tuning of the tunable laser 420. It will be appreciated that, since the integrated system 410 operates in the analog domain and the controller 450 operates in the digital domain, a set of conversion elements may be used to support exchange of information between the integrated system 410 and the controller 450 (e.g., ADCs may be used for sending information from the integrated system 410 to the controller 450 and DACs may be used for sending information from the controller 450 to the integrated system 410).

In FIG. 4, the tunable laser 420 produces a laser output 429. The laser output 429 is output by the integrated system 410. The laser output 429 has a wavelength which may be tuned for the tunable laser 420. The tunable laser 420 includes a set of tunable elements 425 including a phase shifter 426, a first Vernier ring 427, and a second Vernier ring 428. The wavelength of the tunable laser 420 is controlled by three laser tuning signals 421-1 to 421-3 (collectively, laser tuning signals 421) which control the phase shifter 426, the first Vernier ring 427, and the second Vernier ring 428, respectively. The phase shifter 426, the first Vernier ring 427, and the second Vernier ring 428 may be considered to have tunable laser parameters associated therewith, respectively, where the values of the tunable laser parameters that control the phase shifter 426, the first Vernier ring 427, and the second Vernier ring 428 may be controlled by the three laser tuning signals 421-1 to 421-3, respectively. The laser tuning signals 421 which control tuning of the tunable elements 425 for controlling tuning of the tunable laser 420 are generated based on a fast feedback loop from the wavemeter 430 to the set of analog functions 440 (based on a set of tunable parameters supported by the set of analog functions 440) and based on a slow feedback loop controlled by the controller 450 (which controls tuning of the set of tunable parameters of the supported by the set of analog functions 440). Here, as discussed further below, the set of tunable parameters supported by the set of analog functions 440 and tuned by the controller 450 includes drive signals, gain factor signals, and target phase signals. It will be appreciated that, although primarily presented with respect to example embodiments in which specific numbers and types of tunable elements 425 are used for tuning the tunable laser 420, fewer or more tunable elements 425 may be used for tuning the tunable laser 420 (e.g., two elements, four elements, or the like), other types of tunable elements 425 may be used for tuning the tunable laser 420 (e.g., filters, gratings, or the like), or the like, as well as various combinations thereof.

In FIG. 4, the wavemeter 430 is configured to tap a portion of the laser output 429 (denoted as tapped laser output 431), measure the tapped laser output 431, and produce a set of wavemeter electrical signals 439 based on the measurement of the tapped laser output 431. In the example of FIG. 4, although the details are omitted for purposes of clarity, the wavemeter 430 includes four interferometers which produce four pairs of I/Q outputs (illustratively, a first interferometer produces a first pair of I/Q outputs respectively labeled as X0/Y0, a second interferometer produces a second pair of I/Q outputs respectively labeled as X1/Y1, a third interferometer produces a third pair of I/Q outputs respectively labeled as X2/Y2, and a fourth a interferometer produces a fourth pair of I/Q outputs respectively labeled as X3/Y3) that form the wavemeter electrical signals 439-1 - 439-8, respectively, that are output by the wavemeter 430. It will be appreciated that, although primarily presented with respect to an example in which the wavemeter 430 includes four interferometers having four pairs of I/Q outputs, the wavemeter 430 may include fewer or more interferometers providing fewer or more pairs of I/Q outputs. A portion of the wavemeter electrical signals 439 are provided to the set of analog functions 440 (as part of a fast feedback loop that provides direct analog feedback for controlling the wavelength of the laser output 429 based on the set of tunable parameters associated with the set of analog functions 440) and to the controller 450 (as part of a slow feedback loop that enables the controller 450 to control the set of tunable parameters associated with the set of analog functions 440).

In FIG. 4, the set of analog functions 440 includes a set of squaring elements 441-1 - 441-3 (collectively, squaring elements 441), a set of addition element 442-1 - 442-3 (collectively, addition element 442), a gain factor matrix 443 including a set of amplifiers 444, a set of subtraction elements 447-1 - 447-3 (subtraction elements 447), and a set of phase estimators 449-1 - 449-3 (phase estimators 449). The set of tunable parameters associated with the set of analog functions 440 and controlled by the controller 450 includes a set of drive signals 451-1 - 451-3 (collectively, drive signals 451), a set of gain factor signals 453, and a set of target phase signals 455-1 - 455-3 (collectively, target phase signals 455). The drive signals 451 are provided to the addition elements 441 (illustratively, drive signals 451-1 to 451-3 are provided to addition elements 441-1 to 441-3, respectively). The gain factor signals 453 are provided to the gain factor matrix 443. The target phase signals 455 are provided to the subtraction elements 447 (illustratively, target phase signals 455-1 - 455-3 are provided to subtraction elements 447-1 - 447-3, respectively) for comparison with the estimated phases determined by the phase estimators 449 (illustratively, the subtraction elements 447-1 - 447-3 receive estimate phase signals 448-1 - 448-3 provided by the phase estimators 449-1 - 449-3 and the target phase signals 455-1 - 455-3 provided by the controller 450, respectively).

In FIG. 4, the squaring elements 441 have three inputs connected to three outputs of the addition elements 442 and three outputs connected to the phase shifter 426, the first Vernier ring 427, and the second Vernier ring 428 for providing the three laser tuning signals 421 to the phase shifter 426, the first Vernier ring 427, and the second Vernier ring 428, respectively. The squaring elements 441, based on processing of the three modified drive signals output by the three addition elements 442, produce the three laser tuning signals 421 which control the phase shifter 426 (e.g., to control the phase of the laser output 429 of the tunable laser 420), the first Vernier ring 427, and the second Vernier ring 428, respectively. It will be appreciated that, in this arrangement, the three laser tuning signals 421 which control the phase shifter 426, the first Vernier ring 427, and the second Vernier ring 428, respectively, may be considered to be modified versions of the drive signals 451 from the controller 450 and, thus, also may be considered to be (and, thus, also referred to as) drive signals. The laser tuning signals 421 (and, thus, the three drive signals 451 from the controller 450 and the various outputs of the gain factor matrix 443) may be any types of signals suitable for controlling the phase shifter 426, the first Vernier ring 427, and the second Vernier ring 428, respectively (e.g., voltages, currents, or the like, as well as various combinations thereof).

In FIG. 4, the addition elements 442 have three inputs connected to the controller 450 for receiving the three drive signals 451, multiple inputs connected to the multiple outputs of the gain factor matrix 443 for receiving the multiple outputs of the amplifiers 444 of the gain factor matrix 443, and three outputs connected to the three inputs of the squaring elements 441 for providing the modified drive signals to the squaring elements 441, respectively. The addition elements 442, based on addition of the three drive signals 451 from the controller 450 and the multiple outputs of the amplifiers 444 of the gain coefficient matrix 443, produce the three modified drive signals which are provided to the three squaring elements 441 for producing the three laser tuning signals 421 which control the phase shifter 426 (e.g., to control the phase of the laser output 429 of the tunable laser 220), the first Vernier ring 427, and the second Vernier ring 428, respectively. It will be appreciated that, in this arrangement, the three modified drive signals which are used to generate the laser tuning signals 421 which control the phase shifter 426, the first Vernier ring 427, and the second Vernier ring 428, respectively, are modified versions of the drive signals 451 from the controller 450 and, thus, also may be considered to be (and, thus, also referred to as) drive signals. The modified drive signals provided by the addition elements 442 (and, thus, the three drive signals 451 from the controller 450 and the multiple outputs of the amplifiers 444 of the gain factor matrix 443) may be any types of signals suitable for controlling the phase shifter 426, the first Vernier ring 427, and the second Vernier ring 428, respectively (e.g., voltages, currents, or the like, as well as various combinations thereof).

In FIG. 4, the gain factor matrix 443 has three inputs (to three amplifiers 444 of the gain factor matrix 443) connected to the three outputs of the subtraction elements 447 for receiving the output signals of the subtraction elements 447, an input (to the gain factor matrix 443) connected to the controller 450 for receiving the gain factor signals 453, and multiple outputs (from the multiple amplifiers 444 of the gain factor matrix 443) connected to multiple inputs of the three addition elements 442. The amplifiers 444 of the gain factor matrix 443, based on the gain factor signals 453 from the controller 450 and the outputs of the subtraction elements 447, produce the multiple output signals from the multiple amplifiers 444 of the gain factor matrix 443 that are input to the addition elements 442 for controlling the three drive signals 451 from the controller 450 and, thus, producing the three laser tuning signals 421 which control the phase shifter 426, the first Vernier ring 427, and the second Vernier ring 428, respectively. The gain factor matrix 443 may produce the multiple output signals, which are input to the addition elements 442 for controlling the three drive signals 451 that are used to produce the three laser tuning signals 421, by modifying the gain factor signals 453 provided by the controller 450 based on phase difference signals 446 from the subtraction elements 447 (illustratively, based on phase difference signals 446-1 - 446-3 from the subtraction elements 447-1 - 447-3, respectively).

In FIG. 4, the subtraction elements 447 each have one input connected to the output of the corresponding phase estimator 449 for receiving the estimated phase signal 448 from the corresponding phase estimator 449 (illustratively, inputs to subtraction elements 447-1 - 447-3 are connected to outputs of phase estimators 449-1 - 449-3 for receiving the estimated phase signals 448-1 - 448-3, respectively), one input connected to the controller 450 for receiving the corresponding target phase signal 455 from the controller 450 (illustratively, inputs to subtraction elements 447-1 - 447-3 are connected to outputs of controller 450 for receiving the target phase signals 455-1 - 455-3, respectively), and one output connected to the gain factor matrix 443 for providing the corresponding phase difference signal 446 to the gain factor matrix 443. The subtraction elements 447, based on subtraction of the target phase signals 455 from the controller 450 and the estimated phase signals 448 generated based on a portion of the wavemeter electrical signals 439 provided by the wavemeter 430, produces the phase difference signals 446 provided to gain factor matrix 443 for controlling the output signals which are provided to the addition elements 442 for modifying the drive signals 451 to produce the three laser tuning signals 421 which control the phase shifter 426, the first Vernier ring 427, and the second Vernier ring 428, respectively. If there is no phase error, then the estimated phase signal 448 generated based on a portion of the wavemeter electrical signals 439 provided by the wavemeter 430 and the target phase signal 455 from the controller 450 will be equal (i.e., the phase difference signal 446 will be zero), such that there is no adjustment by the gain factor matrix 443 to the gain factor signals 453 from the controller 450 that are used to produce the output signals which are provided to the addition elements 442 for modifying the drive signals 451 to produce the three laser tuning signals 421 which control the phase shifter 426, the first Vernier ring 427, and the second Vernier ring 428, respectively. If there is phase error, then the estimated phase signal 448 generated based on a portion of the wavemeter electrical signals 439 provided by the wavemeter 430 and the phase set point target phase signal 455 from the controller 450 will not be equal (i.e., the phase difference signal 446 will be non-zero), such that there will be some adjustment by the gain factor matrix 443 to the gain factor signals 453 from the controller 450 that are used to produce the output signals which are provided to the addition elements 442 for modifying the drive signals 451 to produce the three laser tuning signals 421 which control the phase shifter 426, the first Vernier ring 427, and the second Vernier ring 428, respectively.

In FIG. 4, the phase estimators 449 each have two inputs connected to two of the wavemeter electrical signals 439 from the wavemeter 430 (illustratively, X0 and Y0 for phase estimator 449-1, X1 and Y1 for phase estimator 449-2, and X2 and Y2 for phase estimator 449-3) and one output connected to an input of the corresponding subtraction element 447 for providing the corresponding estimated phase signal 448 to the corresponding subtraction element 447 for use in generating the corresponding phase difference signal 446 that is provided to the gain factor matrix 443. The phase estimators 449, based on the two corresponding wavemeter electrical signals 439 from the wavemeter 430, produces the corresponding estimated phase signal 448 that is provided to the corresponding subtraction element 447 for use in generating the corresponding phase difference signal 446 that is provided to the gain factor matrix 443, such that the corresponding estimated phase signal 448 is produced in the analog domain directly from the output of the wavemeter 430 as opposed to being produced based on processing by the controller 450. It will be appreciated that, although primarily presented with respect to use of six of the eight wavemeter electrical signals 439 from the wavemeter 430 to produce the estimated phase signals 448 (illustratively, two of the wavemeter electrical signals 439 for each of the three estimated phase signals 448), the estimated phase signals 448 may be produced by the phase estimators 449 using fewer or more of the wavemeter electrical signals 439 from the wavemeter 430.

In FIG. 4, as discussed above, the tunable elements 425 of the tunable laser 420 may be controlled based on the drive signals 451, the gain factor signals 453, and the target phase signals 455. In order to further understand the operation of the system 400 of FIG. 4, consider an example in which the drive signals 451 are implemented as drive currents (e.g., as opposed to voltages or other types of signals suitable for controlling the phase shifter 426, the first Vernier ring 427, and the second Vernier ring 428), the gain factor signals 453 are implemented as currents (e.g., as opposed to voltages or other type of signals), and the target phase signals 455 are implemented as currents (e.g., as opposed to voltages or other type of signals). In this example, assume that the drive signals 451 output by the controller 450 are based on set point values which may be modified by the set of analog functions 440 based on the fast feedback loop (e.g., based on the wavemeter electrical signals 439 received by the set of analog functions 440 from the wavemeter 430) and based on the slow feedback loop (e.g., based on feedback determined by the controller 450 based on the wavemeter electrical signals 439 received by the controller 450 from the wavemeter 430 and provided from the controller 450 to the set of analog functions 440). For example, assume that the set point values of the three drive signals 453-1, 453-2, and 453-3 from the controller 450 are voltages of 0.9mA, 1.3mA, and 0.7mA, respectively. The addition elements 441-1, 441-2, and 441-3 may modify these set points of the three drive signals 451-1, 451-2, and 451-3 from the controller 450, based on the outputs of the gain factor matrix 443, to provide the laser tuning signals 421-1, 421-2, and 421-3 that are applied to control the phase shifter 426, the first Vernier ring 427, and the second Vernier ring 428, respectively. For example, assume that the gain factors of the gain factor matrix cause the set point values of the three drive signals 451-1, 451-2, and 451-3 to be changed from 0.9mA, 1.3mA, and 0.7mA to 1.26mA, 1.41mA, and 0.76mA, respectively. In this manner, the modulation of the drive signals 451 to provide the laser tuning signals 421 that are used to tune the tunable elements 425 may include fast path modulation by the set of analog functions 440 based on the wavemeter eletrical signals 439 from the wavemeter 430 and slow path modulation by the set of analog functions 440 based on the feedback determined by the controller 450 based on the wavemeter eletrical signals 439 from the wavemeter 430.

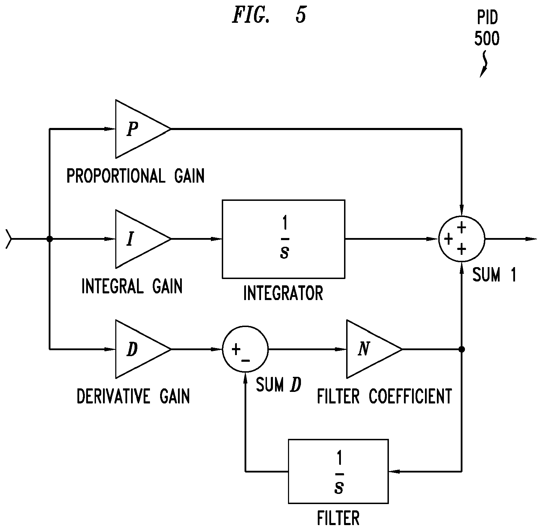

It will be appreciated that, although primarily presented herein with respect to example embodiments in which the gain elements of the set of analog functions (e.g., amplifiers 344 of gain factor matrix 343 of FIG. 3, amplifiers 444 of gain factor matrix 434, or the like) are proportional gain elements, in at least some example embodiments gain elements of the set of analog functions may be proportional integral derivatives (PIDs). It will be appreciated that, in at least some example embodiments, the gain elements of the set of analog functions in FIG. 3 and FIG. 4 may be considered to be the P (proportional) gain elements of PIDs. An example embodiment of a PID, which may be used as a gain element in a set of analog functions, is presented as PID 500 of FIG. 5. It will be appreciated that other suitable types of PIDs may be used as gain elements in the set of analog functions used to control tuning of a tunable laser.

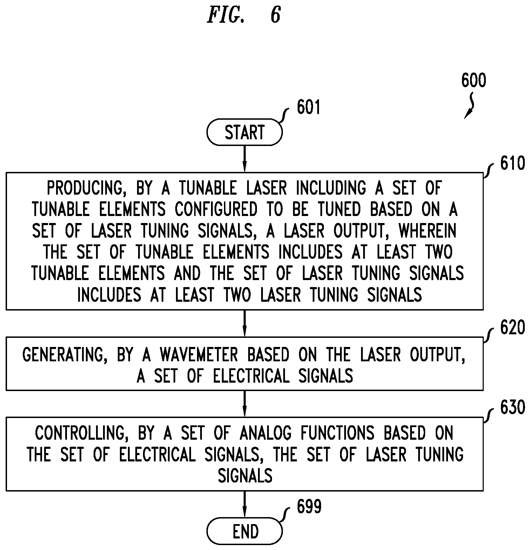

FIG. 6 depicts an example embodiment of a method configured to support stabilization of a tunable laser. It will be appreciated that, although primarily presented as being performed serially, at least a portion of the functions of method 600 may be performed contemporaneously or in a different order than as presented with respect to FIG. 6. At block 601, the method 600 begins. At block 610, producing, by a tunable laser including a set of tunable elements configured to be tuned based on a set of laser tuning signals, a laser output, wherein the set of tunable elements includes at least two tunable elements and the set of laser tuning signals includes at least two laser tuning signals. At block 620, generating, by a wavemeter based on the laser output, a set of electrical signals. At block 630, controlling, by a set of analog functions based on the set of electrical signals, the set of laser tuning signals. At block 699, the method 600 ends. It will be appreciated that the method 600, although depicted as ending for purposes of clarity, may continue to operate (e.g., block 630 may return to block 610 to continue tuning of the tunable laser) in order to support tuning of the tunable laser based on control of the tunable elements of the tunable laser (e.g., method 600 may continue to run as long as the tunable laser operates, as long as tuning of the tunable laser remains activated, or the like).

It will be appreciated that, although primarily presented herein with respect to tuning of specific types of tunable lasers having specific configurations (e.g., a phase shifter and a pair of Vernier rings) based on a mapping between laser parameters of the tunable laser and the wavelength output by the tunable laser, various other types of tunable lasers having various other configurations (e.g., various other tunable elements) may be tuned based on mappings between laser parameters of the tunable lasers (which may vary for different types of tunable lasers) and the wavelengths output by the tunable lasers.

Various example embodiments for supporting tuning of a tunable laser may provide various advantages or potential advantages. For example, various example embodiments for supporting tuning of a tunable laser may support tuning of the tunable laser based on fast feedback from the wavemeter to the tunable laser even though the signals used to tune the tunable laser are different from the signals produced by the wavemeter. For example, various example embodiments for supporting tuning of a tunable laser, by using a fast feedback loop based on direct analog feedback from the wavemeter to the tunable laser, may support stabilization of faster laser fluctuations which might otherwise not be able to be controlled where a high precision wavemeter having a complex multi-channel sine-shaped response as a function of wavelength is used to tune an integrated tunable laser that needs multi-channel ramp-shaped electrical signals in order to linearly sweep wavelength (since, in such configurations, processing the signal to apply to the laser control as a function of the signal generated by the wavemeter generally requires complex processing that can take too much time to stabilize the faster laser fluctuations). Various example supporting tuning of a tunable laser may provide various other advantages or potential advantages.

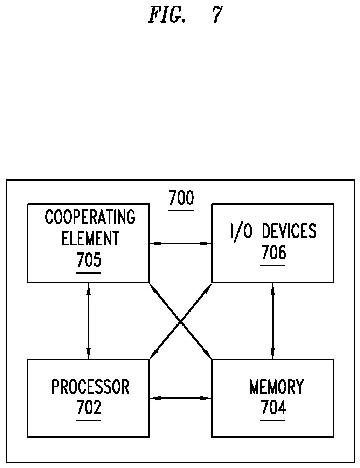

FIG. 7 depicts an example embodiment of a computer suitable for use in performing various functions presented herein.

The computer 700 includes a processor 702 (e.g., a central processing unit (CPU), a processor, a processor having a set of processor cores, a processor core of a processor, or the like) and a memory 704 (e.g., a random access memory, a read only memory, or the like). The processor 702 and the memory 704 may be communicatively connected. In at least some example embodiments, the computer 700 may include at least one processor and at least one memory including a set of instructions which, when executed by the at least one processor, cause the computer 700 to perform various functions presented herein.

The computer 700 also may include a cooperating element 705. The cooperating element 705 may be a hardware device. The cooperating element 705 may be a process that can be loaded into the memory 704 and executed by the processor 702 to implement various functions presented herein (in which case, for example, the cooperating element 705 (including associated data structures) can be stored on a non-transitory computer-readable storage medium, such as a storage device or other suitable type of storage element (e.g., a magnetic drive, an optical drive, or the like)).

The computer 700 also may include one or more input/output devices 706. The input/output devices 706 may include one or more of a user input device (e.g., a keyboard, a keypad, a mouse, a microphone, a camera, or the like), a user output device (e.g., a display, a speaker, or the like), one or more network communication devices or elements (e.g., an input port, an output port, a receiver, a transmitter, a transceiver, or the like), one or more storage devices (e.g., a tape drive, a floppy drive, a hard disk drive, a compact disk drive, or the like), or the like, as well as various combinations thereof.

It will be appreciated that computer 700 may represent a general architecture and functionality suitable for implementing functional elements described herein, portions of functional elements described herein, or the like, as well as various combinations thereof. For example, computer 700 may provide a general architecture and functionality that is suitable for implementing one or more elements presented herein, such as the controller 150, the controller 250, the controller 350, the controller 450, or the like, as well as various combinations thereof.

It will be appreciated that at least some of the functions presented herein may be implemented in software (e.g., via implementation of software on one or more processors, for executing on a general purpose computer (e.g., via execution by one or more processors) so as to provide a special purpose computer, and the like) and/or may be implemented in hardware (e.g., using a general purpose computer, one or more application specific integrated circuits, and/or any other hardware equivalents).

It will be appreciated that at least some of the functions presented herein may be implemented within hardware, for example, as circuitry that cooperates with the processor to perform various functions. Portions of the functions/elements described herein may be implemented as a computer program product wherein computer instructions, when processed by a computer, adapt the operation of the computer such that the methods and/or techniques described herein are invoked or otherwise provided. Instructions for invoking the various methods may be stored in fixed or removable media (e.g., non-transitory computer-readable media), transmitted via a data stream in a broadcast or other signal bearing medium, and/or stored within a memory within a computing device operating according to the instructions.

It will be appreciated that various references herein to specific elements configured to perform specific functions or operations also may be considered to be references to means for performing such functions or operations, as well as various equivalents capable of or configured to perform such functions or operations (e.g., means for providing a laser output may be a tunable laser such as tunable laser 120 or any other suitable means for providing a laser output in accordance with various example embodiments presented herein, means for analyzing a laser output may be a wavemeter such as wavemeter 130 or any other suitable means for analyzing a laser output in accordance with various example embodiments presented herein, means for performing analog operations may be a set of analog functions such as the set of analog functions 140 or any other suitable means for performing analog operations in accordance with various example embodiments presented herein, and so forth).

It will be appreciated that the term "apparatus" may be used herein to refer various systems or portions thereof as described herein (e.g., system 100 of FIG. 1 or portions thereof, system 200 of FIG. 2 or portions thereof, system 300 of FIG. 3 or portions thereof, system 400 of FIG. 4 or portions thereof, and so forth). For example, the term "apparatus" may be used to refer to the integrated system 110, a portion of the integrated system 110 (e.g., the tunable laser 120, the wavemeter 130, the set of analog functions 140, the tunable laser 120 and the wavemeter 130, the tunable laser 120 and the set of analog functions 140, the wavemeter 130 and the set of analog functions 140, or the like), the controller 150, a combination of the integrated system 110 (or portions thereof) and the controller 150, or the like. Similarly, although not described in detail here, it will be appreciated that the term "apparatus" also may be used to refer to the systems, or various portions thereof, of FIGs. 2-4.

It will be appreciated that the term "or" as used herein refers to a non-exclusive "or" unless otherwise indicated (e.g., use of "or else" or "or in the alternative").

It will be appreciated that, although various embodiments which incorporate the teachings presented herein have been shown and described in detail herein, those skilled in the art can readily devise many other varied embodiments that still incorporate these teachings.

**Claims**

1. An apparatus, comprising:

   a tunable laser (120), a wavemeter (130), and means (140) for performing analog operations;
   wherein the tunable laser (120) is configured to produce a laser output, wherein the tunable laser (120) includes a set of tunable elements configured to be tuned based on a set of laser tuning signals, wherein the set of tunable elements includes at least two tunable elements and the set of laser tuning signals includes at least two laser tuning signals;
   **characterized by** that
   the wavemeter (130) includes at least one interferometer configured to provide at least one set of I/Q outputs forming a set of wavemeter electrical signals based on the laser output and to provide the set of wavemeter electrical signals to the means for performing analog operations; and
   wherein the means (140) for performing analog operations is configured to control the set of laser tuning signals based on the set of wavemeter electrical signals so as to analog control an output wavelength of the laser.

2. The apparatus of claim 1, wherein the means for performing analog operations is configured to receive a set of laser drive signals, a set of gain coefficients, and a set of expected wavemeter electrical signals.

3. The apparatus of claim 2, wherein the set of laser tuning signals is generated based on modulation of the set of laser drive signals based on the set of gain coefficients and the set of expected wavemeter electrical signals.

4. The apparatus of claim 1, wherein the means for performing analog operations is configured to receive a set of laser drive signals, a set of gain factor signals, and a phase set point signal.

5. The apparatus of claim 4, wherein the set of laser tuning signals is generated based on modulation of the set of laser drive signals based on the set of gain factor signals and the phase set point signal.

6. The apparatus of claim 1, wherein the means for performing analog operations is configured to receive a set of laser drive signals, a set of gain factor signals, and a set of target phase signals.

7. The apparatus of claim 6, wherein the set of laser tuning signals is generated based on modulation of the set of laser drive signals based on the set of gain factor signals and the set of target phase signals.

8. The apparatus of claim 1, wherein the means for performing analog operations has a set of tunable parameters associated therewith, wherein the set of tunable parameters is controlled based on a set of signals received from a controller.

9. The apparatus of claim 8, wherein the set of signals received from the controller is based on the set of wavemeter electrical signals.

10. The apparatus of claim 1, further comprising:
    a controller configured to receive the set of wavemeter electrical signals from the wavemeter and to control the set of laser tuning signals based on the set of wavemeter electrical signals.

11. The apparatus of claim 10, wherein the controller is configured to provide a set of control signals to the means for performing analog operations based on the set of wavemeter electrical signals, wherein the means for performing analog operations is configured to control the set of laser tuning signals based on the set of control signals.

12. The apparatus of claim 11, wherein the set of control signals includes at least one of a set of expected wavemeter electrical signals, a set of gain coefficients, a set of gain factor signals, a phase set point signal, or a set of target phase signals.

13. The apparatus of claim 10, wherein the controller is configured to provide a set of laser drive signals to the means for performing analog operations, wherein the means for performing analog operations is configured to modulate the set of laser drive signals based on the set of wavemeter electrical signals.

14. A method, comprising:

producing, by a tunable laser (120) including a set of tunable elements configured to be tuned based on a set of laser tuning signals, a laser output, wherein the set of tunable elements includes at least two tunable elements and the set of laser tuning signals includes at least two laser tuning signals;
generating, by a wavemeter (130) including at least one interferometer, based on the laser output, at least one set of I/Q outputs forming a set of wavemeter electrical signals; and
controlling the set of laser tuning signals, by a means (140) for performing analog operations based on the set of wavemeter electrical signals.

**Patentansprüche**

1. Vorrichtung, die Folgendes umfasst:

einen abstimmbaren Laser (120), einen Wellenmesser (130) und Mittel (140) zum Durchführen von analogen Operationen;
wobei der abstimmbarer Laser (120) dazu ausgelegt ist, eine Laserausgabe zu produzieren, wobei der abstimmbarer Laser (120) einen Satz von abstimmbaren Elementen beinhaltet, die dazu ausgelegt sind, auf Basis eines Satzes von Laserabstimmsignalen abgestimmt zu werden, wobei der Satz von abstimmbaren Elementen mindestens zwei abstimmbare Elemente beinhaltet und der Satz von Laserabstimmsignalen mindestens zwei Laserabstimmsignale beinhaltet;
**dadurch gekennzeichnet, dass** der Wellenmesser (130) mindestens ein Interferometer beinhaltet, das dazu ausgelegt ist, mindestens einen Satz von I/Q-Ausgaben bereitzustellen, die auf Basis der Laserausgabe einen Satz von elektrischen Wellenmessersignalen bilden, und den Satz von elektrischen Wellenmessersignalen den Mitteln zum Durchführen von analogen Operationen bereitzustellen; und
wobei die Mittel (140) zum Durchführen von analogen Operationen dazu ausgelegt sind, den Satz von Laserabstimmsignalen auf Basis des Satzes von elektrischen Wellenmessersignalen zu steuern, um eine Ausgangswellenlänge des Lasers analog zu steuern.

2. Vorrichtung nach Anspruch 1, wobei die Mittel zum Durchführen von analogen Operationen dazu ausgelegt sind, einen Satz von Laseransteuersignalen, einen Satz von Verstärkungskoeffizienten und einen Satz von erwarteten elektrischen Wellenmessersignalen zu empfangen.

3. Vorrichtung nach Anspruch 2, wobei der Satz von Laserabstimmsignalen auf Basis einer Modulation des Satzes von Laseransteuersignalen auf Basis des Satzes von Verstärkungskoeffizienten und des Satzes von erwarteten elektrischen Wellenmessersignalen erzeugt werden.

4. Vorrichtung nach Anspruch 1, wobei die Mittel zum Durchführen von analogen Operationen dazu ausgelegt sind, einen Satz von Laseransteuersignalen, einen Satz von Verstärkungsfaktorsignalen und ein Phasensollwertsignal zu empfangen.

5. Vorrichtung nach Anspruch 4, wobei der Satz von Laserabstimmsignalen auf Basis einer Modulation des Satzes von Laseransteuersignalen auf Basis des Satzes von Verstärkungsfaktorsignalen und des Phasensollwertsignals erzeugt werden.

6. Vorrichtung nach Anspruch 1, wobei die Mittel zum Durchführen von analogen Operationen dazu ausgelegt sind, einen Satz von Laseransteuersignalen, einen Satz von Verstärkungsfaktorsignalen und einen Satz von Zielphasensignalen zu empfangen.

**7.** Vorrichtung nach Anspruch 6, wobei der Satz von Laserabstimmsignalen auf Basis einer Modulation des Satzes von Laseransteuersignalen auf Basis des Satzes von Verstärkungsfaktorsignalen und des Satzes von Zielphasensignalen erzeugt wird.

**8.** Vorrichtung nach Anspruch 1, wobei die Mittel zum Durchführen von analogen Operationen einen Satz von abstimmbaren Parametern aufweisen, der damit verknüpft ist, wobei der Satz von abstimmbaren Parametern auf Basis eines Satzes von Signalen, die von einer Steuerung empfangen werden, gesteuert wird.

**9.** Vorrichtung nach Anspruch 8, wobei der Satz von Signalen, der von der Steuerung empfangen wird, auf dem Satz von elektrischen Wellenmessersignalen basiert.

**10.** Vorrichtung nach Anspruch 1, die ferner Folgendes umfasst:
eine Steuerung, die dazu ausgelegt ist, den Satz von elektrischen Wellenmessersignalen vom Wellenmesser zu empfangen und den Satz von Laserabstimmsignalen auf Basis des Satzes von elektrischen Wellenmessersignalen zu steuern.

**11.** Vorrichtung nach Anspruch 10, wobei die Steuerung dazu ausgelegt ist, den Mitteln zum Durchführen von analogen Operationen auf Basis des Satzes von elektrischen Wellenmessersignalen einen Satz von Steuersignalen bereitzustellen, wobei die Mittel zum Durchführen von analogen Operationen dazu ausgelegt sind, den Satz von Laserabstimmsignalen auf Basis des Satzes von Steuersignalen zu steuern.

**12.** Vorrichtung nach Anspruch 11, wobei der Satz von Steuersignalen mindestens eines von einem Satz von erwarteten elektrischen Wellenmessersignalen, einem Satz von Verstärkungskoeffizienten, einem Satz von Verstärkungsfaktorsignalen, einem Phasensollwertsignal oder einem Satz von Zielphasensignalen beinhaltet.

**13.** Vorrichtung nach Anspruch 10, wobei die Steuerung dazu ausgelegt ist, den Mitteln zum Durchführen von analogen Operationen einen Satz von Laseransteuersignalen bereitzustellen, wobei die Mittel zum Durchführen von analogen Operationen dazu ausgelegt sind, den Satz von Laseransteuersignalen auf Basis des Satzes von elektrischen Wellenmessersignalen zu modulieren.

**14.** Verfahren, das Folgendes umfasst:

Produzieren einer Laserausgabe durch einen abstimmbaren Laser (120), der einen Satz von abstimmbaren Elementen beinhaltet, die dazu ausgelegt sind, auf Basis eines Satzes von Laserabstimmsignalen abgestimmt zu werden, wobei der Satz von abstimmbaren Elementen mindestens zwei abstimmbare Elemente beinhaltet und der Satz von Laserabstimmsignalen mindestens zwei Laserabstimmsignale beinhaltet;
Erzeugen von mindestens einem Satz von I/Q-Ausgaben, die einen Satz von elektrischen Wellenmessersignalen bilden, durch einen Wellenmesser (130), der mindestens ein Interferometer beinhaltet, auf Basis der Laserausgabe und
Steuern des Satzes von Laserabstimmsignalen durch Mittel (140) zum Durchführen von analogen Operationen auf Basis des Satzes von elektrischen Wellenmessersignalen.

**Revendications**

**1.** Appareil, comprenant :

un laser accordable (120), un ondemètre (130), et un moyen (140) pour réaliser des opérations analogiques ;
dans lequel le laser accordable (120) est configuré pour produire une sortie laser, dans lequel le laser accordable (120) comporte un ensemble d'éléments accordables configurés pour être accordés sur la base d'un ensemble de signaux d'accord laser, dans lequel l'ensemble d'éléments accordables comporte au moins deux éléments accordables, et l'ensemble de signaux d'accord laser comporte au moins deux signaux d'accord laser ;
**caractérisé en ce que**
l'ondemètre (130) comporte au moins un interféromètre configuré pour fournir au moins un ensemble de sorties I/Q formant un ensemble de signaux électriques d'ondemètre sur la base de la sortie laser, et pour fournir l'ensemble de signaux électriques d'ondemètre au moyen de réalisation d'opérations analogiques ; et
dans lequel le moyen (140) de réalisation d'opérations analogiques est configuré pour commander l'ensemble de signaux d'accord laser sur la base de l'ensemble de signaux électriques d'ondemètre de manière à commander analogiquement une longueur d'onde de sortie du laser.

2. Appareil de la revendication 1, dans lequel le moyen de réalisation d'opérations analogiques est configuré pour recevoir un ensemble de signaux de pilotage de laser, un ensemble de coefficients de gain et un ensemble de signaux électriques d'ondemètre attendus.

3. Appareil de la revendication 2, dans lequel l'ensemble de signaux d'accord laser est généré sur la base d'une modulation de l'ensemble de signaux de pilotage de laser sur la base de l'ensemble de coefficients de gain et de l'ensemble de signaux électriques d'ondemètre attendus.

4. Appareil de la revendication 1, dans lequel le moyen de réalisation d'opérations analogiques est configuré pour recevoir un ensemble de signaux de pilotage de laser, un ensemble de signaux de facteur de gain et un signal de point de consigne de phase.

5. Appareil de la revendication 4, dans lequel l'ensemble de signaux d'accord laser est généré sur la base d'une modulation de l'ensemble de signaux de pilotage de laser sur la base de l'ensemble de signaux de facteur de gain et du signal de point de consigne de phase.

6. Appareil de la revendication 1, dans lequel le moyen de réalisation d'opérations analogiques est configuré pour recevoir un ensemble de signaux de pilotage de laser, un ensemble de signaux de facteur de gain et un ensemble de signaux de phase cible.

7. Appareil de la revendication 6, dans lequel l'ensemble de signaux d'accord laser est généré sur la base d'une modulation de l'ensemble de signaux de pilotage de laser sur la base de l'ensemble de signaux de facteur de gain et de l'ensemble de signaux de phase cible.

8. Appareil de la revendication 1, dans lequel le moyen de réalisation d'opérations analogiques est associé à un ensemble de paramètres accordables, dans lequel l'ensemble de paramètres accordables est commandé sur la base d'un ensemble de signaux reçus d'un dispositif de commande.

9. Appareil de la revendication 8, dans lequel l'ensemble de signaux reçus du dispositif de commande est basé sur l'ensemble de signaux électriques d'ondemètre.

10. Appareil de la revendication 1, comprenant en outre :
un dispositif de commande configuré pour recevoir l'ensemble de signaux électriques d'ondemètre à partir de l'ondemètre, et pour commander l'ensemble de signaux d'accord laser sur la base de l'ensemble de signaux électriques d'ondemètre.

11. Appareil de la revendication 10, dans lequel le dispositif de commande est configuré pour fournir un ensemble de signaux de commande au moyen de réalisation d'opérations analogiques sur la base de l'ensemble de signaux électriques d'ondemètre, dans lequel le moyen de réalisation d'opérations analogiques est configuré pour commander l'ensemble de signaux d'accord laser sur la base de l'ensemble de signaux de commande.

12. Appareil de la revendication 11, dans lequel l'ensemble de signaux de commande comporte au moins un parmi un ensemble de signaux électriques d'ondemètre attendus, un ensemble de coefficients de gain, un ensemble de signaux de facteur de gain, un signal de point de consigne de phase ou un ensemble de signaux de phase cible.

13. Appareil de la revendication 10, dans lequel le dispositif de commande est configuré pour fournir un ensemble de signaux de pilotage de laser au moyen de réalisation d'opérations analogiques, dans lequel le moyen de réalisation d'opérations analogiques est configuré pour moduler l'ensemble de signaux de pilotage de laser sur la base de l'ensemble de signaux électriques d'ondemètre.

14. Procédé, comprenant :

la production, par un laser accordable (120) comportant un ensemble d'éléments accordables configurés pour être accordés sur la base d'un ensemble de signaux d'accord laser, d'une sortie laser, dans lequel l'ensemble d'éléments accordables comporte au moins deux éléments accordables et l'ensemble de signaux d'accord laser comporte au moins deux signaux d'accord laser ;

la génération, par un ondemètre (130) comportant au moins un interféromètre, sur la base de la sortie laser, d'au moins un ensemble de sorties I/Q formant un ensemble de signaux électriques d'ondemètre ; et

la commande de l'ensemble de signaux d'accord laser, par un moyen (140) pour réaliser des opérations analogiques sur la base de l'ensemble de signaux électriques d'ondemètre.

*FIG. 1*

SYSTEM
100

INTEGRATED SYSTEM 110

LASER
OUTPUT
129

TUNABLE LASER
120

TUNABLE
ELEMENTS
125

FAST
FEEDBACK
LOOP
160

ANALOG FUNCTIONS
140

LASER
TUNING
SIGNALS
121

WAVEMETER
130

SLOW
FEEDBACK
LOOP
170

CONTROLLER 150

EP 3 940 900 B1

FIG. 2

FIG. 3

FIG. 4

**TUNABLE LASER 420**

**SYSTEM 400**

TUNABLE ELEMENTS 425

PHASE SHIFTER 426 | FIRST VERNIER RING 427 | SECOND VERNIER RING 428

LASER OUTPUT 429

LASER TUNING SIGNAL 421-1 | LASER TUNING SIGNAL 421-2 | LASER TUNING SIGNAL 421-3

SQUARING ELEMENT 441-1 | SQUARING ELEMENT 441-2 | SQUARING ELEMENT 441-3

ANALOG FUNCTIONS 440

ADDITION ELEMENT 442-1 | ADDITION ELEMENT 442-2 | ADDITION ELEMENT 442-3

ESTIMATED PHASE SIGNAL 448-3
PHASE ESTIMATOR 449-3
SUBTRACTION ELEMENT 447-3
TARGET PHASE SIGNAL 455-3

ESTIMATED PHASE SIGNAL 448-2
PHASE ESTIMATOR 449-2
SUBTRACTION ELEMENT 447-2
TARGET PHASE SIGNAL 455-2

ESTIMATED PHASE SIGNAL 448-1
PHASE ESTIMATOR 449-1
SUBTRACTION ELEMENT 447-1
TARGET PHASE SIGNAL 455-1

GAIN FACTOR MATRIX 443

AMPLIFIERS 444

DRIVE SIGNAL 451-1
DRIVE SIGNAL 451-2
DRIVE SIGNAL 451-3

TAPPED LASER OUTPUT 431

WAVEMETER 430

X0 Y0 X1 Y1 X2 Y2 X3 Y3

ADC CONTROLLER 450 DAC

DAC

GAIN FACTOR SIGNALS 453

EP 3 940 900 B1

FIG.  5

PID
500

PROPORTIONAL GAIN

$P$

$I$ — INTEGRAL GAIN

$\dfrac{1}{s}$ — INTEGRATOR

$D$ — DERIVATIVE GAIN

SUM $D$

$N$ — FILTER COEFFICIENT

$\dfrac{1}{s}$ — FILTER

SUM 1

FIG. 6

600

START  601

610

PRODUCING, BY A TUNABLE LASER INCLUDING A SET OF TUNABLE ELEMENTS CONFIGURED TO BE TUNED BASED ON A SET OF LASER TUNING SIGNALS, A LASER OUTPUT, WHEREIN THE SET OF TUNABLE ELEMENTS INCLUDES AT LEAST TWO TUNABLE ELEMENTS AND THE SET OF LASER TUNING SIGNALS INCLUDES AT LEAST TWO LASER TUNING SIGNALS

620

GENERATING, BY A WAVEMETER BASED ON THE LASER OUTPUT, A SET OF ELECTRICAL SIGNALS

630

CONTROLLING, BY A SET OF ANALOG FUNCTIONS BASED ON THE SET OF ELECTRICAL SIGNALS, THE SET OF LASER TUNING SIGNALS

END  699

*FIG. 7*

**EP 3 940 900 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1291988 A1